# EUROPEAN PATENT APPLICATION

(11) **EP 4 826 764 A1**
(43) Date of publication of application: **21.10.2026**
(21) Application number: 24915126.7
(22) Date of filing: 20.12.2024
(51) Int. Cl.: H01L 23/367

(54) **CHIP MODULE, CHIP MODULE PREPARATION METHOD, AND ELECTRONIC DEVICE**

(30) Priority: 05.01.2024 CN 202410031048
(71) Applicant: Huawei Technologies Co., Ltd., Shenzhen, Guangdong 518129 (CN)
(72) Inventor: YU, Rui, Shenzhen, Guangdong 518129 (CN); WANG, Xiaoyi, Shenzhen, Guangdong 518129 (CN); HUANG, Weichen, Shenzhen, Guangdong 518129 (CN)
(74) Representative: Goddar, Heinz J.
(86) International application number: PCT/CN2024/140825
(87) International publication number: WO 2025/145911

(57) **Abstract**

Embodiments of this application provide a chip module, a chip module manufacturing method, and an electronic device, and pertain to the field of chip technologies. Chips are disposed on two opposite surfaces of a substrate of the chip module. The chips are packaged by using a first encapsulation member and a second encapsulation member, and a first heat dissipation member dissipates heat from a first chip. A layout of the first heat dissipation member is not constrained by factors such as a manufacturing process and a short-circuit prevention spacing, so that a projection of the first heat dissipation member can partially cover a projection of a heat conduction region of the first chip, thereby shortening a heat dissipation path, reducing thermal resistance, and improving heat dissipation performance. An end surface of a first end of the first heat dissipation member is recessed inward relative to a surface that is of the second encapsulation member and that faces away from the substrate, and a preset distance is provided between the end surface and the surface that is of the second encapsulation member and that faces away from the substrate. When an encapsulation layer is thinned to form the second encapsulation member, a thinning removal depth does not reach the first heat dissipation member, thereby avoiding problems such as delamination and cracks at a junction between a side wall of the first heat dissipation member and the encapsulation layer. This improve grindability and reliability of the encapsulation layer and enhances a yield rate.

## Description

This application claims priority to Chinese Patent Application No. 202410031048.2, filed with the China National Intellectual Property Administration on January 5, 2024 and entitled "CHIP MODULE, CHIP MODULE MANUFACTURING METHOD, AND ELECTRONIC DEVICE", which is incorporated herein by reference in its entirety.

### TECHNICAL FIELD

This application relates to the field of chip technologies, and in particular, to a chip module, a chip module manufacturing method, and an electronic device.

### BACKGROUND

With continuous development of chip packaging technologies, chip packaging devices have been widely used in electronic devices such as mobile phones, notebook computers, and smartwatches, for example, a radio frequency chip module in a mobile phone, where a chip device that implements a radio frequency function is integrated through packaging to protect the chip and improve an integration level, while enhancing performance of the entire radio frequency module.

Currently, electronic devices are developing toward a trend of "lightweight, thin, short, and compact" multi-function, and the chip packaging devices are also developing toward a direction of high density, miniaturization, and high pin counts. When heat dissipation performance of the chip packaging device is poor, performance of the chip is greatly affected.

### SUMMARY

Embodiments of this application provide a chip module, a chip module manufacturing method, and an electronic device. The chip module has prominent heat dissipation effect, which is conducive to improvement of performance of the chip module.

A first aspect of embodiments of this application provides a chip module, including a substrate, a first encapsulation member, and a second encapsulation member, where the substrate has a first surface and a second surface that face away from each other in a thickness direction, the first encapsulation member is disposed on the first surface, and the second encapsulation member is disposed on the second surface.

The chip module further includes a plurality of chips. The plurality of chips are separately disposed on the first surface and the second surface, and the chip is at least partially encapsulated in the first encapsulation member or the second encapsulation member. The plurality of chips include the first chip. The first chip has a heat conduction region for implementing heat conduction contact. Heat generated by the first chip in a running process may be transferred to the outside of the first chip through the heat conduction region, so as to dissipate heat from the first chip.

The chip module further includes a first heat dissipation member. The first heat dissipation member is located between the first surface and a surface that is of the second encapsulation member and that faces away from the substrate, at least a first end of the first heat dissipation member is located inside the second encapsulation member, and the first heat dissipation member is configured to dissipate heat from the first chip. In comparison with the related technology in which the chip dissipates heat through a ball grid array including soldering balls, different from a layout requirement of the ball grid array, a layout of the first heat dissipation member is not limited by a manufacturing process and a design for short-circuit prevention, and a short-circuit prevention spacing does not need to be maintained. This ensures that the first heat dissipation member can be distributed beneath the heat conduction region of the first chip. In this way, a vertical projection (projection in the thickness direction) of the first heat dissipation member on the substrate can at least partially cover a vertical projection of the heat conduction region of the first chip on the substrate, so that heat generated by the first chip can be transferred to the first heat dissipation member in the thickness direction through the heat conduction region, and is transferred to the outside of the chip module through the first heat dissipation member, thereby effectively shortening a heat dissipation path of the first chip and having small thermal resistance. In addition, the first heat dissipation member does not need to maintain the short-circuit prevention spacing, so that a large projection coverage area can be implemented, heat dissipation effect is significantly improved, and performance of the first chip and the entire chip module is greatly improved.

An end surface of the first end of the first heat dissipation member is recessed, in the thickness direction, relative to a surface that is of the second encapsulation member and that faces away from the substrate, that is, the end surface of the first end of the first heat dissipation member is recessed, in the thickness direction, relative to the surface that is of the second encapsulation member and that faces away from the substrate. In the thickness direction, a preset distance is provided between the end surface of the first end of the first heat dissipation member and the surface that is of the second encapsulation member and that faces away from the substrate. That is, in a process of thinning an encapsulation layer on the second surface of the substrate, a grinding removal depth (in the thickness direction) does not reach a position (a position of the end surface of the first end) of the first heat dissipation member. After the encapsulation layer is thinned, the first end of the first heat dissipation member is located inside a part of an unremoved encapsulation layer (a thin encapsulation layer). For example, there may be a preset distance between the end surface of the first end of the first heat dissipation member and a surface that is of the thinned encapsulation layer and that faces away from the substrate, and after the second encapsulation member is formed by using the thinned encapsulation layer to make the end surface of the first end of the first heat dissipation member be recessed inward, the preset distance is still reserved between the end surface of the first end of the first heat dissipation member and the surface that is of the second encapsulation member and that faces away from the substrate. The first heat dissipation member is not thinned while the encapsulation layer is thinned, so that problems such as delamination, cracks, or separation at a junction between a circumferential side wall of the first heat dissipation member and the encapsulation layer are avoided during thinning. This can improve grindability and reliability of the surface that is of the encapsulation layer and that faces away from the substrate in the thinning process, improve a yield rate, and avoid occurrence of a problem like a short circuit, thereby achieving high reliability.

In a possible implementation, the preset distance is from 10 µm to 20 µm, to ensure that removal is not performed on a position of the first heat dissipation member during thinning of the encapsulation layer, and after the encapsulation layer is thinned, the first end of the first heat dissipation member is located inside the unremoved thin encapsulation layer, thereby improving reliability and operability of thinning.

In a possible implementation, there are a plurality of heat conduction regions, the plurality of heat conduction regions include at least a first region, the first region is a region with a largest cross-sectional area in the plurality of heat conduction regions, and a vertical projection of the first heat dissipation member on the substrate at least partially covers a vertical projection of the first region on the substrate. In this way, heat generated by the first chip is dissipated through an electrical connecting member with a large cross-sectional area and the first heat dissipation member, thereby further reducing the thermal resistance and implementing favorable heat dissipation for the first chip.

In a possible implementation, the vertical projection of the first heat dissipation member on the substrate covers at least 50% of an area of the vertical projection of the first region on the substrate, so that heat dissipation effect on the first chip can be further improved.

In a possible implementation, the vertical projection of the first heat dissipation member on the substrate covers at least 50% of an area of a vertical projection of the first chip on the substrate, so that the vertical projection of the first heat dissipation member covers a large area of the heat conduction region, thereby implementing favorable heat dissipation for the first chip.

In a possible implementation, the vertical projection of the first heat dissipation member on the substrate completely covers the vertical projection of the first chip on the substrate, to achieve favorable heat dissipation effect on the first chip.

In a possible implementation, the chip module further includes a plurality of spaced conductive members. The conductive member is secured to the second surface, and the conductive member is electrically connected to the chip correspondingly through the substrate. A part of the conductive member is located inside the second encapsulation member, and an end that is of the conductive member and that faces away from the substrate is exposed on the surface that is of the second encapsulation member and that faces away from the substrate, so that the end that is of the conductive member that faces away from the substrate may be electrically connected to the circuit board, thereby implementing an electrical connection between the chip of the chip module and the circuit board.

In a possible implementation, a cross-sectional area of the first heat dissipation member is greater than a cross-sectional area of a conductive member. An area of the vertical projection of the first heat dissipation member on the substrate is greater than an area of a vertical projection of a conductive member on the substrate, so that the first heat dissipation member can cover a large region. The vertical projection of the first heat dissipation member can cover a large area of the heat conduction region. In comparison with heat dissipation of the first chip implemented through the conductive member like a soldering ball, a heat dissipation region is increased, and heat dissipation performance is improved.

In a possible implementation, the cross-sectional area of the first heat dissipation member is greater than π*(D/2)², where D ranges from 200 µm to 300 µm, to ensure that the first heat dissipation member can cover a large area of the heat conduction region, thereby implementing favorable heat dissipation performance.

In a possible implementation, a thermal conductivity coefficient of the first heat dissipation member is greater than 100 W/mK. The first heat dissipation member dissipates heat from the first chip, to ensure small thermal resistance and achieve favorable heat dissipation effect.

In a possible implementation, a thickness of the first heat dissipation member is greater than 30 µm, to ensure that the first heat dissipation member has favorable heat conduction performance, so as to facilitate implementation of favorable heat dissipation effect on the first chip.

In a possible implementation, the surface that is of the second encapsulation member and that faces away from the substrate has a groove, and the groove extends to the first end of the first heat dissipation member, to expose a part of the first end of the first heat dissipation member, so that heat of the first chip can be transferred to the outside of the chip module through the first heat dissipation member, thereby ensuring heat dissipation performance of the first heat dissipation member.

In a possible implementation, the chip module further includes a first connecting member, the first connecting member is secured to the first end of the first heat dissipation member, and an end that is of the first connecting member and that faces away from the first heat dissipation member is disposed to protrude from the surface that is of the second encapsulation member and that faces away from the substrate. The first heat dissipation member may be secured and assembled together with the circuit board through the first connecting member, to improve assembly stability of the chip module and the circuit board, and may also transfer heat to the circuit board to implement heat dissipation, thereby achieving favorable heat dissipation effect.

The end that is of the first connecting member and that faces away from the first heat dissipation member may protrude from the surface that is of the second encapsulation member and that faces away from the substrate, that is, the first connecting member is disposed to protrude from the second encapsulation member, to facilitate assembly and a connection between the first connecting member and the circuit board.

In a possible implementation, there is a gap between the first connecting member and the second encapsulation member, so that the first connecting member has high interface flexibility during forming, thereby improving a forming yield rate of the first connecting member. A part of the first heat dissipation member may still be exposed from the surface that is of the second encapsulation member and that faces away from the substrate.

In a possible implementation, the end that is of the conductive member and that faces away from the substrate is disposed to protrude from the surface that is of the second encapsulation member and that faces away from the substrate, so that the conductive member is exposed outside the second encapsulation member, thereby facilitating an electrical connection between the conductive member and the circuit board.

In a possible implementation, there is a gap between the conductive member and the second encapsulation member, so that the conductive member has high interface flexibility during forming, thereby improving a forming yield rate of the conductive member.

In a possible implementation, the conductive member and the first connecting member are respectively soldering balls, to implement assembly of the conductive member, the first connecting member, and an external circuit board.

In a possible implementation, the first chip is disposed on the first surface, a surface that is of the first chip and that faces the substrate has a first electrical connecting member, and the first chip is electrically connected to the substrate through the first electrical connecting member. An end surface of an end that is of the first electrical connecting member and that is connected to the substrate forms the heat conduction region.

In a possible implementation, in the thickness direction, the first heat dissipation member further includes a second end opposite to the first end, and the second end of the first heat dissipation member is secured to the second surface. That is, the first chip and the first heat dissipation member are respectively located on the first surface and the second surface of the substrate that are opposite to each other, resulting in a simple structural design. During manufacturing of the chip module, the first heat dissipation member may also be disposed on the second surface when the chip is disposed on the second surface. This is fully compatible with an existing manufacturing process of a chip module packaged using a die-size ball grid array in a related technology, without introducing any additional process, thereby helping reduce costs.

In a possible implementation, the substrate has a second heat dissipation member, and vertical projections of the second heat dissipation member and the first heat dissipation member on the substrate at least partially overlap. The thermal resistance on the heat dissipation path from the first chip to the first heat dissipation member is reduced, thereby further improving heat dissipation effect.

In a possible implementation, the second heat dissipation member is located inside the substrate. That is, the second heat dissipation member is located between the first surface and the second surface, and the second heat dissipation member is not exposed from the first surface and the second surface of the substrate. This improves the heat dissipation effect and simplifies the structural design for ease of implementation.

In a possible implementation, one end of the second heat dissipation member is located inside the substrate, the other end of the second heat dissipation member extends into the second encapsulation member in the thickness direction, and the second end of the first heat dissipation member is secured to the other end of the second heat dissipation member. This helps increase a thickness of the second heat dissipation member, further reduce the thermal resistance, and enrich securing and assembling manners for the first heat dissipation member and the second surface of the substrate, thereby providing greater structural design flexibility.

In a possible implementation, in the thickness direction, the second end of the first heat dissipation member is secured inside the substrate. That is, the first heat dissipation member is inserted into the substrate, a portion of the first heat dissipation member is located inside the substrate, and another portion of the first heat dissipation member is located inside the second encapsulation member. While further reducing the thermal resistance and improving heat dissipation effect, this arrangement helps reduce a quantity of heat dissipation members disposed on the substrate, simplifies a structural design and a forming process, and contributes to cost reduction.

In a possible implementation, the first chip is disposed on the second surface, a surface that is of the first chip and that faces the substrate has a second electrical connecting member, and the first chip is electrically connected to the substrate through the second electrical connecting member.

The first heat dissipation member is secured to a surface that is of the first chip and that faces away from the substrate, and a surface that is of the first chip and that faces the first heat dissipation member forms the heat conduction region, thereby further shortening the heat dissipation path, reducing the thermal resistance, and improving heat dissipation efficiency.

In a possible implementation, the first chip includes a power amplifier, and the chip module is a radio frequency module.

A second aspect of embodiments of this application provides a chip module manufacturing method. The method includes:
providing a substrate, a first heat dissipation member, and a plurality of chips, where the substrate includes a first surface and a second surface that face away from each other in a thickness direction; and the plurality of chips include a first chip, and the first chip has a heat conduction region for implementing heat conduction contact;
disposing a part of the plurality of chips on the first surface, and forming a first encapsulation member on the first surface, where the chip located on the first surface is at least partially encapsulated in the first encapsulation member;
disposing the other part of the plurality of chips on the second surface, where at least a first end of the first heat dissipation member is located on the second surface, and a vertical projection of the first heat dissipation member on the substrate at least partially covers a vertical projection of the heat conduction region of the first chip on the substrate;
forming an encapsulation layer on the second surface, where the encapsulation layer encapsulates the chips and the first heat dissipation member that are located on the second surface;
thinning the encapsulation layer to form a thin encapsulation layer, where the first end of the first heat dissipation member is encapsulated in the thin encapsulation layer; and
processing the thinned encapsulation layer to form a second encapsulation member, to enable an end surface of the first end of the first heat dissipation member to be recessed, in the thickness direction, relative to a surface that is of the second encapsulation member and that faces away from the substrate, where the chip located on the second surface is at least partially encapsulated in the second encapsulation member, the first heat dissipation member is located between the first surface and the surface that is of the second encapsulation member and that faces away from the substrate, and in the thickness direction, a preset distance is provided between the end surface of the first end of the first heat dissipation member and the surface that is of the second encapsulation member and that faces away from the substrate.

In the method, the first heat dissipation member is disposed, and the vertical projection of the first heat dissipation member on the substrate at least partially covers the vertical projection of the heat conduction region of the first chip on the substrate, so that excellent heat dissipation performance of the first chip can be implemented. In addition, after the encapsulation layer is thinned, it is ensured that the first end of the first heat dissipation member is located inside the thinned encapsulation layer formed through thinning. For example, there may be a preset distance between the end surface of the first end of the first heat dissipation member and a surface that is of the thinned encapsulation layer and that faces away from the substrate, and the first heat dissipation member is not exposed on the surface that is of the thinned encapsulation layer and that faces away from the substrate. After the thinned encapsulation layer is processed to form the second encapsulation member to enable the end surface of the first end of the first heat dissipation member to be recessed relative to a surface of the second encapsulation member, the preset distance is still reserved between the end surface of the first end and the surface that is of the second encapsulation member and that faces away from the substrate. That is, in a process of thinning the encapsulation layer, a grinding removal depth (in the thickness direction) does not reach a position of the first heat dissipation member, and the first heat dissipation member is not thinned while the encapsulation layer is thinned. This avoids problems such as delamination, cracks, or separation at a junction between a circumferential side wall of the first heat dissipation member and the encapsulation layer in the grinding and thinning process, thereby improving grindability and reliability of the encapsulation layer, improving a yield rate, and avoiding a problem like a short circuit.

In a possible implementation, before the forming the encapsulation layer on the second surface, the method further includes: forming a plurality of spaced soldering joint members on the second surface, where the soldering joint members are electrically connected to the chip through the substrate.

The forming the encapsulation layer on the second surface further includes: encapsulating the soldering joint member by using the encapsulation layer.

After the forming the encapsulation layer on the second surface, the method further includes: thinning the soldering joint member to form a conductive member, where an end that is of the conductive member and that faces away from the substrate is exposed on the surface that is of the second encapsulation member and that faces away from the substrate. In the method, the conductive member is formed on the second surface of the substrate, and the conductive member is exposed from the second encapsulation member, to implement an electrical connection between the conductive member and an external circuit board.

In a possible implementation, the thinning the soldering joint member to form the conductive member includes:
thinning the soldering joint member to form a transition soldering joint;
forming a notch structure on a surface that is of the thinned encapsulation layer and that faces away from the substrate, where the notch structure is disposed around the transition soldering joint; and
disposing a first solder structure on the transition soldering joint, and performing reflow processing on the transition soldering joint and the first solder structure to form the conductive member, where the end that is of the conductive member and that faces away from the substrate is disposed to protrude from the surface that is of the second encapsulation member and that faces away from the substrate. In the method, the conductive member is disposed to protrude from the second encapsulation member. In addition, the notch structure is disposed to increase interface flexibility of the transition soldering joint and the first solder structure. This facilitates reflow forming of the conductive member, and is especially conducive to forming of a spherical conductive member.

In a possible implementation, the processing the thinned encapsulation layer to form the second encapsulation member includes: providing a groove on the surface that is of the thinned encapsulation layer and that faces away from the substrate to form the second encapsulation member, where the groove extends to the first end of the first heat dissipation member. In this way, the end surface of the first end of the first heat dissipation member is recessed, in the thickness direction, relative to the surface that is of the second encapsulation member and that faces away from the substrate, thereby ensuring that there is a preset distance between the end surface of the first end of the first heat dissipation member and the surface that is of the second encapsulation member and that faces away from the substrate. The groove may expose a part of the first end of the first heat dissipation member, so that heat of the first chip can be transferred to the outside of the chip module through the first heat dissipation member.

In a possible implementation, after the providing the groove on the surface that is of the thinned encapsulation layer and that faces away from the substrate, the method further includes:
disposing a second solder structure on the first end of the first heat dissipation member; and
performing reflow processing on the second solder structure to form a first connecting member, where an end that is of the first connecting member and that faces away from the first heat dissipation member is disposed to protrude from the surface that is of the second encapsulation member and that faces away from the substrate. In the method, the first connecting member is formed on the first heat dissipation member, so that the first heat dissipation member is connected to the external circuit board or the like through the first connecting member.

In a possible implementation, a surface that is of the first chip and that faces the substrate has a first electrical connecting member, and the disposing the part of the plurality of chips on the first surface includes: disposing the first chip on the first surface, and enabling the first chip to be electrically connected to the substrate through the first electrical connecting member, where an end surface of an end that is of the first electrical connecting member and that is connected to the substrate forms the heat conduction region.

In a possible implementation, in the thickness direction, the first heat dissipation member further includes a second end opposite to the first end.

The providing the substrate and the first heat dissipation member includes: securing the second end of the first heat dissipation member to the second surface. In the method, a chip module whose layout manner is that the first chip is located on the first surface and the first heat dissipation member is located on the second surface can be obtained.

In a possible implementation, the substrate has a second heat dissipation member.

The securing the second end of the first heat dissipation member to the second surface includes: enabling the vertical projection of the first heat dissipation member on the substrate to at least partially overlap a vertical projection of the second heat dissipation member on the substrate. In the method, the chip module having the second heat dissipation member is obtained, to improve heat dissipation effect.

In a possible implementation, one end of the second heat dissipation member is located inside the substrate, and the other end of the second heat dissipation member extends into the second encapsulation member in the thickness direction.

The securing the second end of the first heat dissipation member to the second surface includes: forming a second connecting member on the other end of the second heat dissipation member, to enable the second end of the first heat dissipation member to be secured to the other end of the second heat dissipation member through the second connecting member. In the method, a chip module whose layout manner is that the first chip is located on the first surface, the first heat dissipation member is located on the second surface, one end of the second heat dissipation member is located inside the substrate, and the other end is secured to the first heat dissipation member can be obtained.

In a possible implementation, the providing the substrate and the first heat dissipation member includes: securing the second end of the first heat dissipation member inside the substrate. In the method, a chip module whose layout manner is that the first chip is located on the first surface, and the first heat dissipation member is partially secured inside the substrate can be obtained.

In a possible implementation, a surface that is of the first chip and that faces the substrate has a second electrical connecting member.

The disposing the other part of the plurality of chips on the second surface includes:
disposing the first chip on the second surface, and electrically connecting the first chip to the substrate through the second electrical connecting member; and
securing the first heat dissipation member to a surface that is of the first chip and that faces away from the substrate, where a surface that is of the first chip and that faces the first heat dissipation member forms the heat conduction region.

According to the method, a chip module whose layout manner is that the first chip is located on the second surface and the first heat dissipation member is located on the first chip can be obtained.

A second aspect of embodiments of this application provides an electronic device, including a housing, a circuit board, and the chip module according to any one of the foregoing. The chip module is disposed on the circuit board, the chip module is electrically connected to the circuit board, and both the chip module and the circuit board are assembled in the housing.

### BRIEF DESCRIPTION OF DRAWINGS

FIG. 1 is a diagram of a cross-sectional structure of an electronic device according to an embodiment of this application;
FIG. 2 is a diagram of a cross-sectional structure of assembling a chip module and a circuit board in a related technology;
FIG. 2a is a bottom view of a structure of a chip module in a related technology;
FIG. 3 is a diagram of a cross-sectional structure of a chip module according to an embodiment of this application;
FIG. 4 is a bottom view of a structure of the chip module in FIG. 3;
FIG. 5 is a diagram of a cross-sectional structure of another chip module according to an embodiment of this application;
FIG. 6 is a diagram of assembling the chip module in FIG. 5 and a circuit board;
FIG. 7 is a diagram of a cross-sectional structure of still another chip module according to an embodiment of this application;
FIG. 8 is a diagram of a junction-to-board thermal resistance model of a first chip in the chip module in FIG. 7;
FIG. 9 is a diagram of simulation of heat conduction of a first chip in a ball grid array chip module in a related technology;
FIG. 10 is a diagram of simulation of heat conduction of a first chip in the chip module in FIG. 7;
FIG. 11 is a diagram of a cross-sectional structure of yet another chip module according to an embodiment of this application;
FIG. 12 is a diagram of a cross-sectional structure of still another chip module according to an embodiment of this application;
FIG. 13 is a diagram of a cross-sectional structure of still another chip module according to an embodiment of this application;
FIG. 14 is a diagram of a cross-sectional structure of still another chip module according to an embodiment of this application;
FIG. 15 is a schematic flowchart of a chip module manufacturing method according to an embodiment of this application;
FIG. 15a is a diagram in which a part of chips are assembled on a substrate in a chip module according to an embodiment of this application;
FIG. 15b is a diagram in which a first encapsulation member is formed on a substrate in a chip module according to an embodiment of this application;
FIG. 15c is a diagram in which a chip and a soldering joint member are assembled on a substrate in a chip module according to an embodiment of this application;
FIG. 15d is a diagram in which an encapsulation layer is formed on a second surface of a substrate in a chip module according to an embodiment of this application;
FIG. 15e is a diagram of a thinned encapsulation layer in a chip module according to an embodiment of this application;
FIG. 15f is a diagram in which a second encapsulation member is formed in a chip module according to an embodiment of this application;
FIG. 15g is a diagram in which a first solder structure and a second solder structure are disposed on a first heat dissipation member in a chip module according to an embodiment of this application;
FIG. 15h is a bottom view in which a first solder structure and a second solder structure are disposed on a first heat dissipation member in a chip module according to an embodiment of this application; and
FIG. 15i is a diagram in which reflow is performed on a first solder structure in a chip module according to an embodiment of this application.

### Descriptions of reference numerals:

100: electronic device;
101: housing; 101a: side frame; 101b: rear cover;
102: display;
   10: chip module;
      11: substrate; 11a: first surface; 11b: second surface; 112: second heat dissipation member;
      12a: first chip; 12b: second chip; 12c: third chip; 12d: fourth chip;
      13: first encapsulation member; 14: second encapsulation member;
      15: conductive member;
      17: first heat dissipation member;
      18: groove; 19: second groove;
      110: first connecting member;
      120: second connecting member;
      130: first solder structure; 140: second solder structure;
   20: circuit board; and
104: antenna module.

### DESCRIPTION OF EMBODIMENTS

Terms used in implementations of this application are only used to explain specific embodiments of this application, but are not intended to limit this application.

Embodiments of this application provide an electronic device. The electronic device may include but is not limited to electronic devices such as a mobile phone, a tablet computer (tablet computer), a notebook computer, an ultra-mobile personal computer (ultra-mobile personal computer, UMPC for short), a desktop computer, a walkie-talkie, a netbook, a personal digital assistant (personal digital assistant, PDA for short), a wearable device, a virtual reality (virtual reality, VR for short) device (for example, VR glasses, and a VR helmet), an augmented reality (augmented reality, AR for short) device (for example AR glasses and an AR helmet), a vehicle-mounted device, and a surveillance camera device that have a wireless communication function.

In embodiments of this application, an example in which an electronic device is a mobile phone is used for description.

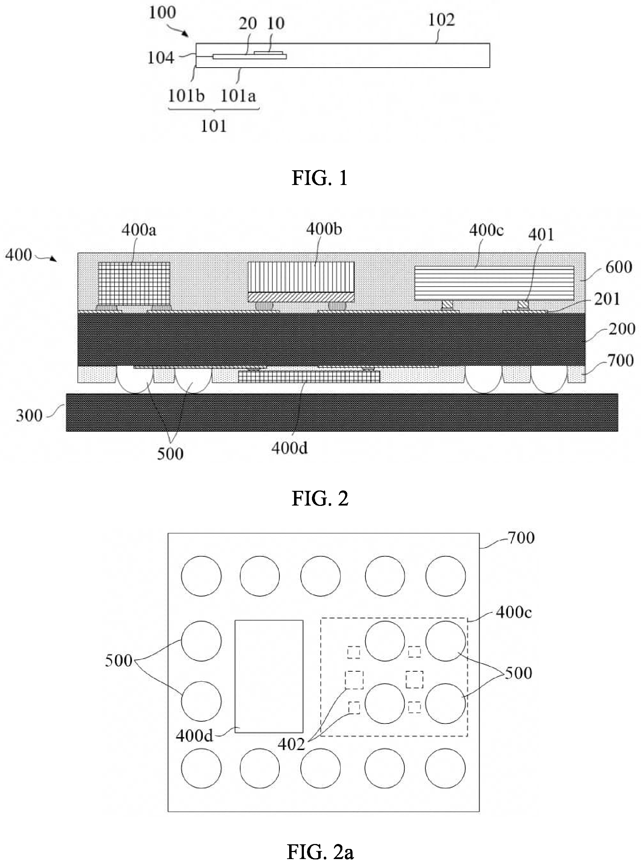

FIG. 1 is a diagram of a cross-sectional structure of an electronic device according to an embodiment of this application;
Refer to FIG. 1. An electronic device 100 may include a housing 101 and a display 102. The housing 101 may include a rear cover 101b and a side frame 101a. The rear cover 101b and the display 102 may be respectively located on two opposite sides of the side frame 101a. The rear cover 101b, the side frame 101a, and the display 102 may enclose accommodating space. The accommodating space is used to accommodate structural components of the electronic device 100.

The electronic device 100 may further include an antenna module 104. For example, in some examples, a part of the side frame 101a may be configured to form the antenna module 104.

The electronic device 100 may further include a circuit board 20 and a chip module 10. The circuit board 20 and the chip module 10 are separately assembled in the accommodating space. The chip module 10 is disposed on the circuit board 20. The chip module 10 is electrically connected to the circuit board 20, to implement signal transmission between the chip module 10 and the circuit board 20.

For example, the chip module 10 may be a radio frequency module. The radio frequency module may be configured to modulate a frequency of a received electrical signal (for example, an electrical signal sent by a processor of the electronic device 100), and amplify power. For example, in a process of transmitting the electrical signal to the outside of the electronic device 100, the radio frequency module may modulate the electrical signal from a low frequency to a specified high frequency band, to become a radio frequency signal that can be transmitted over air, and amplify power of the radio frequency signal to meet a communication requirement.

The circuit board 20 may be electrically connected to the antenna module 104, to implement an electrical connection between the chip module 10 and the antenna module 104.

The chip module 10 may transmit a radio frequency (radio frequency, RF for short) signal, and transfer the radio frequency signal to the antenna module 104 through the circuit board 20. The antenna module 104 may send the radio frequency signal. The antenna module 104 may alternatively receive an external electromagnetic wave signal, and transfer the electromagnetic wave signal to the chip module 10.

Certainly, in some other examples, the chip module 10 may alternatively be another chip integration module, for example, may be a storage chip module. In this embodiment of this application, an example in which the chip module 10 is a radio frequency module is used for description.

It may be understood that the structure shown in embodiments of this application does not constitute a specific limitation on the electronic device 100. In some other embodiments of this application, the electronic device 100 may include more or fewer structural components than those shown in the figure, or combine some structural components, or split some structural components, or have different structural component arrangements. For example, the electronic device 100 may further include structural components such as a camera (for example, a front-facing camera or a rear-facing camera), a sensor, a memory, a battery, and a flash.

With development of electronic devices toward lightness and thinness, chip modules gradually develop toward high density, miniaturization, and high pin counts. A ball grid array packaging technology has advantages such as a small packaging size and high density, and becomes one of common chip packaging technologies. In particular, a chip module packaged in a die-size ball grid array (die-size ball grid array, DSBGA for short) is widely used and researched.

FIG. 2 is a diagram of a cross-sectional structure of assembling a chip module and a circuit board in a related technology.

Refer to FIG. 2. A chip module 400 packaged in a DABGA may include a substrate 200 and a plurality of chips, and the plurality of chips may be electrically connected to routing traces (not shown in the figure) in the substrate 200.

The substrate 200 may include a front side and a back side that are opposite to each other, and the plurality of chips may be separately disposed on the front side and the back side of the substrate 200. For example, as shown in FIG. 2, the plurality of chips may include a chip 400a, a chip 400b, a chip 400c, and a chip 400d. The chip 400a, the chip 400b, and the chip 400c may be located on the front side of the substrate 200, and the chip 400d may be located on the back side of the substrate 200.

A plurality of soldering balls 500 may be secured to the back side of the substrate 200, and the plurality of soldering balls 500 are arranged in an array to form a ball grid array (with reference to FIG. 2a). The chip may be electrically connected to the plurality of soldering balls 500 separately through the routing traces of the substrate 200.

For example, a surface that is of the chip and that faces the substrate 200 may have a copper bump configured to implement an electrical connection. As shown in FIG. 2, the chip 400c on the front side of the substrate 200 is used as an example. A surface that is of the chip 400c and that faces the front side of the substrate 200 has a copper bump 401. A routing trace 201 in the substrate 200 may extend to the front side of the substrate 200. The chip 400c may be in contact with and electrically connected to the routing trace 201 through the copper bump 401, to implement an electrical connection between the chip 400c and the substrate 200, and further be electrically connected to the soldering ball 500 located on the back side of the substrate 200 through the routing trace 201.

A molding material of the soldering ball 500 is often a tin ball. For example, the molding material of the soldering ball 500 may be an alloy material including three metal components: tin (Sn), silver (Ag), and copper (Cu), for example, may be an SAC305 material, that is, mass percentages of Sn, Ag, and Cu are: 96.5%, 3.0%, and 0.5%.

The front surface of the substrate 200 may further be covered with a front-side encapsulation member 600, where the front-side encapsulation member 600 encapsulates and packages at least a part of the chip on the front surface. The back surface of the substrate 200 may be covered with a back-side encapsulation member 700, where the back-side encapsulation member 700 encapsulates and packages at least a part of a chip on the back surface. The plurality of soldering balls 500 are also located inside the back-side encapsulation member 700, and an end that is of each soldering ball 500 and that faces away from the substrate 200 is disposed to protrude from the back-side encapsulation member 700, to expose the soldering ball 500.

Still refer to FIG. 2. The chip module 400 may be soldered to the circuit board 300 through the plurality of soldering balls 500, and implement electrical connections, so that the plurality of chips are electrically connected to the circuit board 300.

Heat dissipation of the plurality of chips may alternatively be implemented through the ball grid array including the soldering balls 500. Heat generated by the chip in a running process may be transferred to the substrate 200, and then dissipated outward through the soldering balls 500, thereby achieving heat dissipation of the chip module. A region of the chip in contact with the substrate 200 may be a heat conduction region of the chip. For example, the chip 400c is used as an example. A copper bump 401 of the chip 400c is electrically connected to the substrate 200, and the chip 400c transfers heat to the substrate 200 through the copper bump 401, to implement heat dissipation of the chip 400c. An end surface of an end that is of the copper bump 401 and that is in contact with the substrate 200 may be used as the heat conduction region 402 of the chip 400c (with reference to FIG. 2a).

FIG. 2a is a bottom view of a structure of a chip module in a related technology. A dashed line in FIG. 2a shows a vertical projection of the chip 400c on the back-side encapsulation member 700.

However, a distribution manner of the ball grid array is fixed, and is limited by a manufacturing process of the ball grid array. Refer to FIG. 2a. Spacings need to be reserved between the plurality of soldering balls 500 in the ball grid array. In this way, a problem like a short circuit caused by contact between the soldering balls 500 can also be avoided. It is difficult to ensure that the soldering balls 500 are precisely arranged beneath the heat conduction region 402 of the chip. As shown in FIG. 2a, that is, vertical projections of the soldering balls 500 on the substrate (or the back-side encapsulation member 700) cannot cover a vertical projection of the heat conduction region 402 of the chip 400c on the substrate, which increases a heat dissipation path. In addition, the back-side encapsulation member 700 is often a plastic package, which has a low thermal conductivity coefficient (for example, 1 W/(mK)). This increases thermal resistance, and causes poor heat dissipation performance. In addition, soldering balls are often tin balls, and a thermal conductivity coefficient is also low (for example, 58 W/(mK)). A cross-sectional area of each soldering ball is small, which is not conducive to heat dissipation and reduces heat dissipation effect on the chip, and consequently, performance of the chip is affected, especially for a heat-sensitive chip, for example, a power amplifier (power amplifier, PA for short) in a radio frequency module. Poor heat dissipation effect on the PA greatly affects a function of the PA, and further affects performance of the entire chip module.

In view of this, an embodiment of this application provides a chip module and a chip module manufacturing method. A chip in the chip module may be electrically connected to a substrate through a conductive member (for example, a ball grid array assembled by a plurality of conductive soldering balls). A first heat dissipation member is disposed in the chip module, so that the first heat dissipation member is configured to dissipate heat from a first chip that is heat-sensitive or heat-intensive. In comparison with heat dissipation of the chip through a ball grid array including soldering balls, the first heat dissipation member is not limited by a forming process and a local requirement, and there is no need to reserve a short-circuit prevention spacing or the like, so that it can be ensured that the first heat dissipation member may be arranged beneath a heat conduction region of the first chip, that is, it can be ensured that a vertical projection of the first heat dissipation member on the substrate covers at least a part of a vertical projection of the heat conduction region of the first chip on the substrate. This effectively shortens a heat dissipation path of the first chip, provides small thermal resistance and a large coverage area, significantly improves heat dissipation performance, and enables the first chip and the entire chip module to achieve superior performance.

In addition, an end surface of a first end of the first heat dissipation member is recessed, in a thickness direction, relative to a surface that is of the second encapsulation member and that faces away from the substrate, and a preset distance is reserved between the end surface of the first end of the first heat dissipation member and the surface that is of the second encapsulation member and that faces away from the substrate. That is, in a process of thinning an encapsulation layer, a grinding removal depth does not reach the first heat dissipation member. After thinning, the first end of the first heat dissipation member is located inside an unremoved part of the encapsulation layer (a thin encapsulation layer). After a second encapsulation member is formed, a preset distance is reserved between the end surface of the first end of the first heat dissipation member and a surface that is of the second encapsulation member and that faces away from the substrate. The first heat dissipation member is not thinned while the encapsulation layer is thinned, so that problems such as delamination, cracks, or separation at a junction between a circumferential side wall of the first heat dissipation member and the encapsulation layer are avoided during thinning. This can improve grindability and reliability of the surface that is of the encapsulation layer and that faces away from the substrate in the thinning process, improve a yield rate, and avoid occurrence of a problem like a short circuit, thereby achieving high reliability.

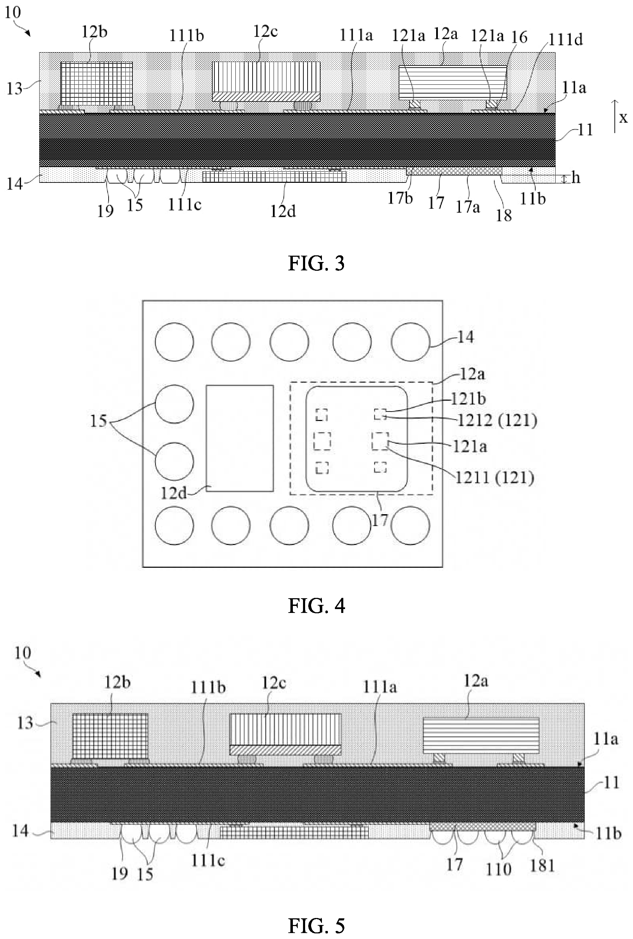

FIG. 3 is a diagram of a cross-sectional structure of a chip module according to an embodiment of this application.

Refer to FIG. 3. A chip module 10 includes a substrate 11, and the substrate 11 may be used as a supporting structural member of the entire chip module 10. For example, the substrate 11 may be a square plate-like structural member, and a thickness direction of the substrate 11 is an x direction shown in FIG. 3.

The substrate 11 may include a first surface 11a and a second surface 11b that face away from each other. For example, two side surfaces of the substrate 11 that are away from other in the x direction may be the first surface 11a and the second surface 11b.

The chip module 10 further includes a plurality of chips. The plurality of chips may be radio frequency chips (radio frequency integrated circuit, RFIC), power amplifiers, low noise amplifiers (low noise amplifier, LNA for short), surface acoustic waves (surface acoustic wave, SAW for short), switches (switch, SW for short), and the like.

For example, the plurality of chips may include a first chip 12a. The first chip 12a may be a chip that is heat-intensive in the plurality of chips, or the first chip 12a may be a heat-sensitive chip. For example, heat dissipation effect on the first chip 12a greatly affects performance of the first chip 12a. For example, in this embodiment of this application, an example in which the first chip 12a is a PA is used for description.

As shown in FIG. 3, the plurality of chips may be the first chip 12a, a second chip 12b, a third chip 12c, and a fourth chip 12d, and the first chip 12a, the second chip 12b, the third chip 12c, and the fourth chip 12d may be: a PA, an RFIC, an SWA, and an LNA/SW.

The plurality of chips may be separately disposed on the first surface 11a and the second surface 11b. As shown in FIG. 3, for example, the first chip 12a, the second chip 12b, and the third chip 12c may be separately disposed on the first surface 11a, and the fourth chip 12d may be disposed on the second surface 11b.

The chip module 10 further includes a first encapsulation member 13 and a second encapsulation member 14. The first encapsulation member 13 and the second encapsulation member 14 can protect packaging of the chip, and at least a part of each chip may be encapsulated and packaged in the first encapsulation member 13 or the second encapsulation member 14. For example, the first encapsulation member 13 is disposed on the first surface 11a, the first encapsulation member 13 may cover the first surface 11a, and the chip located on the first surface 11a is at least partially encapsulated and in inside the first encapsulation member 13. For example, the first chip 12a, the second chip 12b, and the third chip 12c are encapsulated and packaged in the first encapsulation member 13.

The second encapsulation member 14 is disposed on the second surface 11b, the second encapsulation member 14 may cover the second surface 11b, and the chip located on the second surface 11b is at least partially encapsulated and packaged in the second encapsulation member 14. For example, the fourth chip 12a may be partially encapsulated and packaged in the second encapsulation member 14.

A molding material of the first encapsulation member 13 may include a material such as plastic, ceramic, resin, or glass, and a molding material of the second encapsulation member 14 may be the same as the molding material of the first encapsulation member 13.

It should be noted that the chip is at least partially encapsulated and packaged in the first encapsulation member 13 or the second encapsulation member 14, and the chip may be located inside the encapsulation member and is not exposed. For example, chips (such as the first chip 12a, the second chip 12b, and the third chip 12c) located on the first surface 11a are encapsulated in the first encapsulation member 13, and there is a spacing between a surface that is of the chip and that faces away from the substrate 11 and a surface that is of the first encapsulation member 13 and that faces away from the substrate 11.

Alternatively, the chip may be partially encapsulated in the encapsulation member, and partially exposed from the encapsulation member. For example, the chip (for example, the fourth chip 12d) located on the second surface 11b is partially located inside the second encapsulation member 14, and partially exposed from a surface that is of the second encapsulation member 14 and that faces away from the substrate. For example, the surface that is of the chip and that faces away from the substrate 11 may be flush with the surface that is of the second encapsulation member 14 and that faces away from the substrate 11, so that the chip is partially exposed.

Certainly, in some examples, the chip located on the first surface 11a may alternatively be exposed from the first encapsulation member 13. For example, the surface that is of the chip and that faces away from the substrate 11 may be flush with the surface that is of the first encapsulation member 13 and that faces away from the substrate 11. The chip located on the second surface 11b may alternatively be encapsulated in the second encapsulation member 14 without being exposed. A specific disposition position of the chip in the encapsulation member may be selected and set based on a function requirement of the chip.

Still refer to FIG. 3. The chip module 10 further includes a plurality of conductive members 15, and the plurality of conductive members 15 are spaced. Each conductive member 15 is secured to the second surface 11b of the substrate 11, and the conductive member 15 is partially encapsulated in the second encapsulation member 14. The conductive member 15 may be electrically connected to the chip through the substrate 11, so that the chip may be electrically connected to an external circuit board through the conductive member.

For example, the substrate 11 may have a plurality of routing traces, and the routing traces may be configured to implement an electrical connection between chips. For example, refer to FIG. 3. The substrate 11 may have a routing trace 111a and a routing trace 111b. The routing trace 111a and the routing trace 111b may extend to the first surface 11a. The first chip 12a and the third chip 12c may be electrically connected through the routing trace 111a, and the second chip 12b and the third chip 12c may be electrically connected through the routing trace 111b.

The routing trace may also be configured to implement an electrical connection between the chip and the conductive member. For example, refer to FIG. 3. The substrate 11 may further have a routing trace 111c, the routing trace 111c may extend to the second surface 11b, and the routing trace 111c may be electrically connected to the fourth chip 12d and the conductive member 15 separately. It should be noted that FIG. 3 shows only a part of the conductive members 15 and a part of the routing traces. For example, the substrate 11 may further have a routing trace 111d, the routing trace 111d may extend to the first surface 11a, and the first chip 12a may be electrically connected to a conductive member (not shown in the figure) located on the second surface 11b through the routing trace 111d.

In some examples, the chip may have an electrical connecting member, to implement an electrical connection to the substrate. For example, the first chip 12a is disposed on the first surface 11a of the substrate 11. A surface that is of the first chip 12a and that faces the first surface 11a of the substrate 11 may have a first electrical connecting member 121a, and the first chip 12a is disposed on the first surface 11a and is in contact with and electrically connected, through the first electrical connecting member 121a, to the routing traces (such as the routing trace 111d and the routing trace 111a) extending to the first surface 11a, thereby achieving an electrical connection between the chip and the substrate 11

There may be a plurality of electrical connecting members of the chip, to meet an electrical connection requirement of the chip. For example, refer to FIG. 3. The first chip 12a has two first electrical connecting members 121a. One of the first electrical connecting members 121a of the first chip 12a may be in contact with and electrically connected to the routing trace 111d, of the substrate 11, extending to the first surface 11a, so that the first chip 12a may be electrically connected to the conductive member through the first electrical connecting member 121a and the routing trace 111d. The other first electrical connecting member 121a of the first chip 12a may be in contact with and electrically connected to the routing trace 111a, of the substrate 11, extending to the first surface 11a, so that the first chip 12a may be electrically connected to the third chip 12c through the first electrical connecting member 121a and the routing trace 111a.

For example, a routing trace between the electrical connecting member and the substrate 11 may be secured through soldering, to ensure a stable electrical connection. For example, the chip module may further include a soldering member 16. For example, the first electrical connecting member 121a of the first chip 12a in FIG. 3 is electrically connected to the routing trace 111d, and the first electrical connecting member 121a is connected to the routing trace 111d through soldering through the soldering member 16, to implement reliable assembly and the electrical connection between the first electrical connecting member 121a of the first chip and the substrate 11.

The soldering member 16 may be a soldering structural member like a soldering joint or a soldering pad. Certainly, in some other examples, the electrical connecting member and the substrate 11 may be assembled, secured, and electrically connected in another manner. For example, the electrical connecting member of the chip may be secured and electrically connected to the routing trace of the substrate through a clamping member, a fastener, or the like that is conductive.

In some other examples, the chip may alternatively be electrically connected to the substrate 11 in another manner. For example, a surface of the chip may be fitted with the substrate 11, the surface that is of the chip and that faces away from the substrate 11 may have a lead, and the chip may be electrically connected to the substrate 11 through the lead.

It may be understood that a type and a quantity of chips, and a manner of connecting the chip to the substrate may be selected and set based on a function of the chip module 10 and an actual requirement, and a quantity and a layout manner of routing traces may alternatively be selected and set based on a connection requirement of the chips.

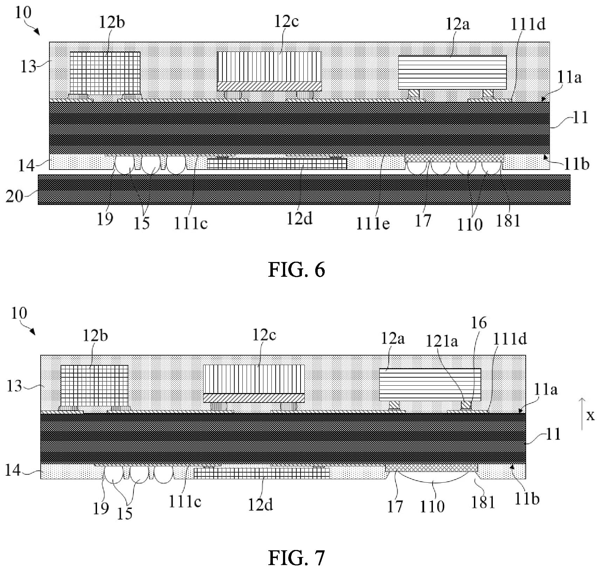

An end that is of each conductive member 15 and that faces away from the substrate 11 is exposed from the second encapsulation member 14, that is, the end that is of the conductive member 15 and that faces away from the substrate 11 may be exposed on the surface that is of the second encapsulation member 14 and that faces away from the substrate 11, so that the end that is of the conductive member 15 and that faces away from the substrate 11 may be electrically connected to the circuit board 20 (with reference to FIG. 6), thereby implementing an electrical connection between the chip of the chip module 10 and the circuit board.

For example, the end that is of the conductive member 15 and that faces away from the substrate 11 may be disposed to protrude from the surface that is of the second encapsulation member 14 and that faces away from the substrate 11, so that the conductive member 15 is exposed outside the second encapsulation member 14, thereby facilitating an electrical connection between the conductive member 15 and the circuit board 20.

For example, the conductive member 15 may be a soldering ball, namely, a spherical soldering member. For example, the conductive member 15 may be a soldering ball made of an SAC305 material. The conductive member 15 may be soldered and secured to the conductive member on the circuit board through soldering, to implement the electrical connection.

It should be noted that the conductive member 15 is partially encapsulated in the second encapsulation member 14, an outer wall surface of the conductive member 15 may extend to the second encapsulation member 14, and the outer wall surface of the conductive member 15 is fitted with the second encapsulation member 14. Alternatively, still refer to FIG. 3. There may be a gap 19 between the outer wall surface of the conductive member 15 and the second encapsulation member, so that the conductive member 15 has high interface flexibility in a forming process. For example, in a process of manufacturing the spherical conductive member 15, there may be a gap between a molding material of the conductive member 15 and the second encapsulation member to form the gap 19 after the conductive member 15 is formed, so that the molding material of the conductive member has high interface flexibility. This facilitates spherical forming of the conductive member 15, and improves a forming yield rate of the conductive member 15.

The chip of the chip module 10 generates heat in a running process. To ensure performance of the chip, heat generated by the chip needs to be dissipated. The chip may have the heat conduction region used to implement heat conduction contact. The heat generated by the chip in the running process may be transferred to the outside of the chip through the heat conduction region, to dissipate heat from the chip. For example, if the chip is disposed on the substrate 11, there is a heat conduction contact region between the chip and the substrate 11, heat of the chip may be transferred to the substrate 11 through the heat conduction contact region, to dissipate heat from the chip. The heat conduction contact region between the chip and the substrate 11 may be the heat conduction region of the chip.

For example, in an example in which the chip is electrically connected to the substrate 11 through the electrical connecting member, an end surface of an end that is of the electrical connecting member and that is connected to the substrate 11 may be the heat conduction region of the chip. Refer to FIG. 3. An example in which the first chip 12a is disposed on the first surface 11a of the substrate 11 is used. The first electrical connecting member 121a of the first chip 12a is electrically connected to the routing trace 111d of the substrate 11, and heat generated by the first chip 12a may be transferred to the substrate 11 through the first electrical connecting member 121a, to implement heat dissipation of the first chip 12a. The end surface of the end that is of the first electrical connecting member 121a and that is connected to the substrate 11 may form the heat conduction region 121 of the first chip 12a (with reference to FIG. 4).

Certainly, in some other examples, when the chip implements heat transfer in another manner, the heat conduction region may alternatively be another contact region for implementing heat transfer by the chip. For example, in an example in which a surface of the chip is fitted with the substrate 11, heat generated by the chip is transferred to the substrate 11 through the surface that is of the chip and that is fitted with the substrate 11, and the surface that is of the chip and that is fitted with the substrate 11 may form the heat conduction region of the chip. Alternatively, in some other examples, the chip is disposed on the substrate 11. When the chip may be fitted with a heat dissipation member (for example, a first heat dissipation member) whose thermal conductivity coefficient is higher than that of the substrate 11, heat generated by the chip is transferred to the heat dissipation member through a surface that is of the chip and that is fitted with the heat dissipation member, to dissipate heat from the chip. The surface that is of the chip and that is fitted with the heat dissipation member may form the heat conduction region of the chip.

Still refer to FIG. 3. To improve heat dissipation effect on the first chip 12a, the chip module 10 further includes a first heat dissipation member 17. The first heat dissipation member 17 may be located between the first surface 11a of the substrate 11 and the surface that is of the second encapsulation member 14 and that faces away from the substrate 11, that is, the first heat dissipation member 17 is not exposed from the first surface 11a.

In addition, the first heat dissipation member is at least partially encapsulated in the second encapsulation member 14. For example, the first heat dissipation member 17 may include a first end 17a and a second end 17b that are opposite in a thickness direction (x direction). The second end 17b may be disposed close to the first surface 11a, the first end 17a may be disposed far away from the first surface 11a, and at least the first end 17a of the first heat dissipation member 17 is located inside the second encapsulation member 14. The second end 17b may extend to the substrate 11, so that the first heat dissipation member 17 may be partially located inside the substrate 11, and partially located inside the second encapsulation member 14. Alternatively, the second end 17b may be secured to the second surface 11b of the substrate 11.

FIG. 4 is a bottom view of a structure of the chip module in FIG. 3. A dashed line in FIG. 4 shows a vertical projection of the first chip 12a on the second encapsulation member 14.

The first heat dissipation member 17 may be configured to dissipate heat from the first chip 12a. It may be understood that, in comparison with a related technology in which the chip dissipates heat through a ball grid array including soldering balls, different from a layout requirement of the ball grid array, a layout of the first heat dissipation member 17 is not limited by a design like a manufacturing process and a short-circuit prevention design. Refer to FIG. 3. It is ensured that the first heat dissipation member 17 can be distributed beneath the heat conduction region (namely, the first electrical connecting member 121a) of the first chip 12a. With reference to FIG. 4, a vertical projection (projection in the x direction) of the first heat dissipation member 17 on the substrate (or the second encapsulation member 14) can at least partially cover a vertical projection (projection in the x direction) of the heat conduction region 121 of the first chip 12a on the substrate (or the second encapsulation member 14), so that heat generated by the first chip 12a can be transferred to the first heat dissipation member 17 in the x direction through the heat conduction region 121, and is transferred by the first heat dissipation member 17 to the outside of the chip module 10, to implement heat dissipation. This effectively shortens a heat dissipation path and provides small thermal resistance. In addition, the first heat dissipation member 17 does not need to maintain a short-circuit prevention spacing, so that a large projection coverage area can be implemented, heat dissipation effect is significantly improved, and performance of the first chip 12a and the entire chip module 10 is greatly improved.

It should be noted that the conductive member 15 may alternatively be configured to implement heat dissipation for the chip. For example, a part of the conductive member 15 overlaps the vertical projection of the heat conduction region of the chip on the substrate 11, and heat generated in a running process of the chip may alternatively be transferred to the outside of the chip module 10 through the conductive member 15.

A molding material of the first heat dissipation member 17 may be a material having a high thermal conductivity coefficient, for example, the thermal conductivity coefficient of the first heat dissipation member 17 is greater than a thermal conductivity coefficient of the conductive member 15.

For example, the thermal conductivity coefficient of the first heat dissipation member 17 may be greater than 100 W/mK, and heat dissipation of the first chip 12a is implemented through the first heat dissipation member 17, to ensure small thermal resistance and achieve favorable heat dissipation effect.

For example, in some examples, the thermal conductivity coefficient of the first heat dissipation member 17 may be 200 W/mK to 600 W/mK, so that the thermal resistance can be further reduced, heat dissipation effect can be improved, and favorable heat dissipation effect can be achieved for the first chip 12a.

In some examples, the thermal conductivity coefficient of the first heat dissipation member 17 may be approximately 400 W/mK. For example, the molding material of the first heat dissipation member 17 may include metal copper, so that favorable heat dissipation effect can be achieved, and costs are low, thereby facilitating production implementation.

Certainly, in some other examples, the first heat dissipation member 17 may alternatively be made of another type of metal material, for example, a material such as aluminum or silver.

For example, a thickness of the first heat dissipation member 17 may be greater than 30 µm, to ensure that the first heat dissipation member 17 has favorable heat conduction performance, so as to facilitate implementation of favorable heat dissipation effect on the first chip 12a.

For example, in some examples, the thickness of the first heat dissipation member 17 may be from 40 µm to 50 µm, which helps achieve favorable heat dissipation effect. For example, the thickness of the first heat dissipation member 17 may be approximately from 40 µm or 50 µm, so that the first heat dissipation member 17 can achieve favorable heat dissipation effect.

The first heat dissipation member 17 may be a structural member. For example, the first heat dissipation member 17 may be an entire heat dissipation block, and a shape of the first heat dissipation member 17 may be a cylinder, a cube, or another regular or irregular shape.

Alternatively, the first heat dissipation member 17 may include a plurality of sub-heat dissipation members. For example, each sub-heat dissipation member may be a heat dissipation block, and a shape of each sub-heat dissipation member may be a cylinder, a cube, or another regular or irregular shape.

A cross-sectional area of the first heat dissipation member 17 may be greater than a cross-sectional area of the conductive member 15. In embodiments of this application, the cross-sectional area is an area of a cross-sectional region formed by cutting a component (for example, the first heat dissipation member or the conductive member) along a plane perpendicular to the thickness direction (x direction). An area of the vertical projection of the first heat dissipation member 17 on the substrate is greater than an area of a vertical projection of a conductive member 15 on the substrate, so that the first heat dissipation member 17 can cover a large region. The vertical projection of the first heat dissipation member 17 can cover a large area of the heat conduction region. In comparison with heat dissipation of the first chip implemented through the conductive member like a soldering ball, a heat dissipation region is increased, and heat dissipation performance is improved.

For example, the cross-sectional area of the first heat dissipation member 17 may be greater than π*(D/2)², where D may be a diameter of a spherical conductive member 15. For example, D may range from 200 µm to 300 µm, to ensure that the first heat dissipation member 17 can cover a large area of the heat conduction region, thereby implementing favorable heat dissipation performance.

It should be noted that the first chip 12a may include a plurality of heat conduction regions 121. For example, the first chip 12a is electrically connected to the substrate through an electrical connecting member. A plurality of electrical connecting members may be disposed on a surface that is of the first chip 12a and that faces the substrate. Refer to FIG. 4. For example, the first chip 12a has a first electrical connecting member 121a and a third electrical connecting member 121b, the first chip 12a is electrically connected to the substrate through the first electrical connecting member 121a and the third electrical connecting member 121b. An end surface of an end that is of the first electrical connecting member 121a and that is connected to the substrate and an end surface of an end that is of the third electrical connecting member 121b and that is connected to the substrate each may form a heat conduction region 121 of the first chip 12a.

In some examples, a vertical projection of the first heat dissipation member 17 on the substrate may completely cover vertical projections of a plurality of heat conduction regions 121 on the substrate, to achieve favorable heat dissipation effect.

Alternatively, in some examples, the vertical projection of the first heat dissipation member 17 on the substrate may cover only a part of the vertical projections of the heat conduction regions 121 on the substrate, to achieve favorable heat dissipation effect, reduce an area of the first heat dissipation member 17, and help reduce structural design difficulty and production costs.

For example, the plurality of heat conduction regions may include at least a first region, and the first region is a region having a largest cross-sectional area in the plurality of heat conduction regions. For example, the end surface of the end that is of the first electrical connecting member 121a and that is connected to the substrate forms a heat conduction region 1211, and the end surface of the end that is of the third electrical connecting member 121b and that is connected to the substrate forms a heat conduction region 1212. A cross-sectional area of the first electrical connecting member 121a may be a largest cross-sectional area in the plurality of electrical connecting members, so that the heat conduction region 1211 may be a region that has the largest cross-sectional area in the plurality of heat conduction regions 121, that is, the heat conduction region 1211 may be the first region.

The vertical projection of the first heat dissipation member 17 on the substrate may at least partially cover a vertical projection of the first region on the substrate, so that heat generated by the first chip 12a is dissipated through the electrical connecting member having a large cross-sectional area and the first heat dissipation member 17, thereby further reducing thermal resistance and implementing favorable heat dissipation for the first chip 12a.

For example, the vertical projection of the first heat dissipation member 17 on the substrate covers at least 50% of an area of the vertical projection of the first region on the substrate, so that heat dissipation effect on the first chip 12a can be further improved.

In some examples, for example, the vertical projection of the first heat dissipation member 17 on the substrate may cover 80% to 90% of an area of the vertical projection of the first region on the substrate, so that heat dissipation effect on the first chip 12a is favorable.

For example, the vertical projection of the first heat dissipation member 17 on the substrate may cover at least 50% of the area of the vertical projection of the first chip 12a on the substrate, so that the vertical projection of the first heat dissipation member 17 covers a large area of the heat conduction region 121, thereby implementing favorable heat dissipation for the first chip 12a.

For example, the vertical projection of the first heat dissipation member 17 on the substrate may cover 80% to 90% of the area of the vertical projection of the first chip 12a on the substrate, and may further improve heat dissipation effect on the first chip 12a.

In some examples, the vertical projection of the first heat dissipation member 17 on the substrate may completely cover the vertical projection of the first chip 12a on the substrate, to achieve favorable heat dissipation effect on the first chip 12a. It should be noted that a shape, a cross-sectional area size, and the like of the first heat dissipation member 17 may be the same as a shape, a cross-sectional area size, and the like of the first chip 12a, so that the vertical projection of the first heat dissipation member 17 on the substrate may completely coincide with the vertical projection of the first chip 12a on the substrate. Alternatively, the cross-sectional size of the first heat dissipation member 17 may be greater than the cross-sectional size of the first chip 12a, so that the area of the vertical projection of the first heat dissipation member 17 on the substrate may be greater than the vertical projection of the first chip 12a on the substrate, and the projection of the first heat dissipation member 17 completely covers the projection of the first chip 12a.

It may be understood that, to transfer the heat of the chip module 10 to the outside of the chip module 10, the first heat dissipation member 17 may be exposed or the first heat dissipation member 17 may be connected in contact with another structural member, to transfer the heat and implement heat dissipation. For example, the first heat dissipation member 17 may be connected to a circuit board, to transfer the heat of the chip module 10 to the circuit board, so as to implement heat dissipation.

To expose the first heat dissipation member or connect the first heat dissipation member to another structural member, the first heat dissipation member needs to be exposed from the second encapsulation member. For example, after an encapsulation layer is covered on the second surface, thinning such as grinding and removal may be performed on the encapsulation layer to form the second encapsulation member, and the conductive member and the first heat dissipation member are exposed. Due to existence of a process tolerance or the like, to ensure exposure of the first heat dissipation member, a part of the first heat dissipation member usually needs to be removed through grinding, that is, a grinding removal depth (the thickness in the x direction) of the encapsulation layer needs to reach a position at which a part of the first heat dissipation member can be removed, and the first heat dissipation member is thinned while the encapsulation layer is thinned. However, because a molding material of the first heat dissipation member is different from a molding material of the encapsulation layer, during thinning, problems such as delamination, cracks, or separation easily occur at a position of a junction between a circumferential side wall of the first heat dissipation member and the encapsulation layer, resulting in a low yield rate. In addition, when the chip module is secured to the circuit board through soldering or the like, solder on the circuit board easily enters the layered, cracked, or separated part, thereby causing a problem like a short circuit.

Refer to FIG. 3. Therefore, in this embodiment of this application, an end surface of the first end of the first heat dissipation member 17 is recessed, in the thickness direction, relative to the surface that is of the second encapsulation member 14 and that faces away from the substrate 11, that is, the end surface of the first end of the first heat dissipation member 17 is recessed inward from the surface that is of the second encapsulation member 14 and that faces away from the substrate 11. In the thickness direction (the x direction), a distance from the end surface of the first end of the first heat dissipation member 17 to the second surface 11b is less than a distance from the surface that is of the second encapsulation member 14 and that faces away from the substrate 11 to the second surface 11b. In this way, a preset distance is maintained, in the x direction, between the end surface of the first end of the first heat dissipation member 17 and the surface that is of the second encapsulation member 14 and that faces away from the substrate 11. It should be noted that because the end surface of the first end of the first heat dissipation member 17 is recessed inward from the surface that is of the second encapsulation member 14 and that faces away from the substrate 11, the surface that is of the second encapsulation member 14 and that faces away from the substrate 11 is actually non-planar. To illustrate that, there is a preset distance, in the x direction, between the end surface of the first end of the first heat dissipation member 17 and the surface that is of the second encapsulation member 14 and that faces away from the substrate 11, the surface that is of the second encapsulation member 14 and that faces away from the substrate 11 may be a virtual plane, and the virtual plane may be consistent with a surface, facing away from the substrate, of a thinned encapsulation layer (an unremoved part of the encapsulation layer) formed by thinning the encapsulation layer. The preset distance between the end surface of the first end of the first heat dissipation member 17 and the surface that is of the second encapsulation member 14 and that faces away from the substrate 11 may be a preset distance, in the thickness direction, between the virtual plane and the end surface of the first end of the first heat dissipation member 17, for example, h shown in FIG. 3.

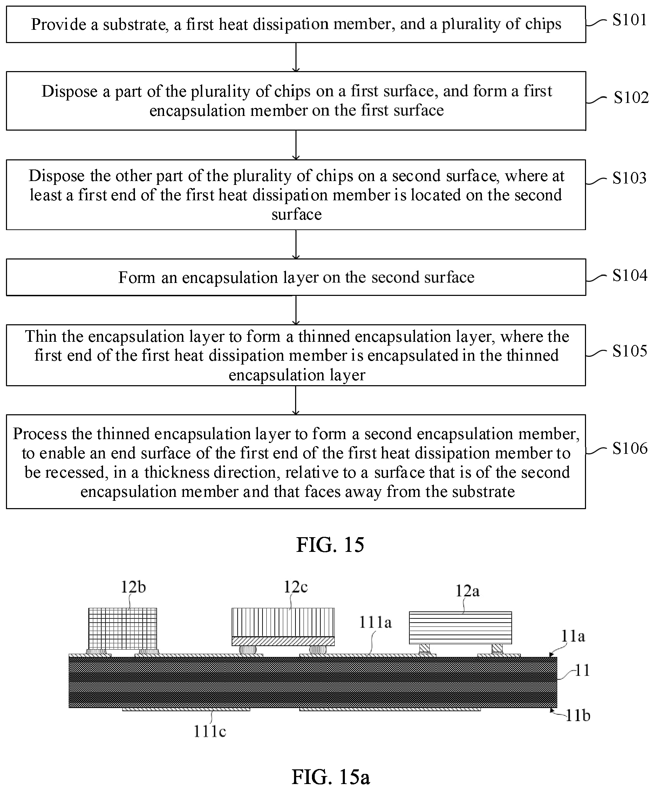

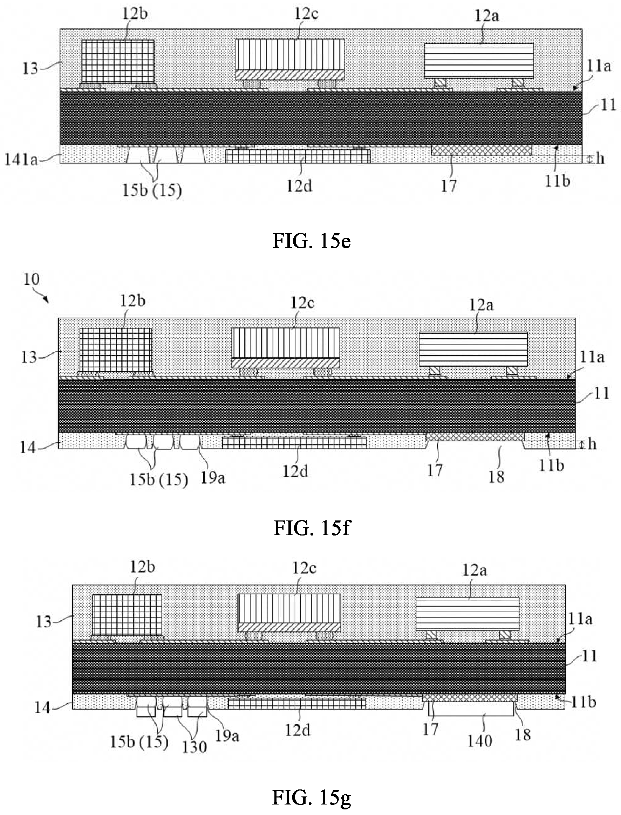

In a process of thinning the encapsulation layer, a grinding removal depth (the thickness in the x direction) does not reach a position of the first heat dissipation member 17 (a position of the end surface of the first end). After the encapsulation layer is thinned, the first end of the first heat dissipation member 17 is located inside the unremoved part of the encapsulation layer (the thin encapsulation layer) (with reference to FIG. 15e). For example, there may be the preset distance between the end surface of the first end of the first heat dissipation member 17 and the surface that is of the thinned encapsulation layer and that faces away from the substrate, and after the second encapsulation member 14 is formed based on the thin encapsulation layer, to make the end surface of the first end of the first heat dissipation member 17 be recessed inward relative to a surface of the second encapsulation member 14, the preset distance is still reserved between the end surface of the first end of the first heat dissipation member 17 and the surface that is of the second encapsulation member 14 and that faces away from the substrate 11. The first heat dissipation member is not thinned while the encapsulation layer is thinned, so that problems such as delamination, cracks, or separation easily occur at a junction between the circumferential side wall of the first heat dissipation member 17 and the encapsulation layer are avoided during thinning, grindability and reliability of the surface that is of the encapsulation layer and that faces away from the substrate 11 can be improved during thinning, a yield rate can be improved, and a problem like a short circuit can be avoided, thereby achieving high reliability.

For example, a range of the preset distance h between the end surface of the first end of the first heat dissipation member 17 and the surface that is of the second encapsulation member 14 and that faces away from the substrate 11 may be from 10 µm to 20 µm. This ensures that the first heat dissipation member 17 is not removed during thinning of the encapsulation layer. After thinning, the first end of the first heat dissipation member 17 is located inside the unremoved thin encapsulation layer, thereby improving reliability and operability of thinning.

In some examples, refer to FIG. 3. The surface that is of the second encapsulation member 14 and that faces away from the substrate 11 may have a groove 18. For example, the thinned encapsulation layer may be processed through laser grooving or another manner to form the second encapsulation member 14, and the groove 18 is formed on the surface that is of the second encapsulation member 14 and that faces away from the substrate 11. The groove 18 may be located on a surface that is of the first heat dissipation member 17 and that faces away from the substrate 11, and the groove 18 extends to the first end of the first heat dissipation member 17, so that the end surface of the first end of the first heat dissipation member 17 is recessed inward relative to the surface that is of the second encapsulation member 14 and that faces away from the substrate 11.

For example, the first end of the first heat dissipation member 17 may be partially exposed, through the groove 18, on the surface that is of the second encapsulation member 14 and that faces away from the substrate 11, so that heat of the first chip 12a may be transferred to the outside of the chip module 10 through the first heat dissipation member 17, or the first end of the first heat dissipation member 17 is connected to another structural member.

For example, when the chip module 10 is connected to and assembled with the circuit board, the first end of the first heat dissipation member 17 may be secured to and assembled with the circuit board, so that heat of the first chip 12a can be transferred to the circuit board for heat dissipation. For example, refer to FIG. 4. An end that is of the conductive member 15 and that faces away from the substrate and an end that is of the first heat dissipation member 17 and that faces away from the substrate may be separately exposed from the second encapsulation member 14. When the chip module 10 is connected to and assembled with the circuit board, the end that is of the conductive member 15 and that faces away from the substrate may be secured to and electrically connected to the circuit board through soldering, and an exposed part of the first heat dissipation member 17 may be secured to and assembled with the circuit board, so that heat of the first chip is transferred to the outside of the chip module.

A shape of the groove 18 may be a circle. Alternatively, in some examples, the shape of the groove 18 may be another regular or irregular pattern like a rectangle or an ellipse.

FIG. 5 is a diagram of a cross-sectional structure of another chip module according to an embodiment of this application.

Alternatively, in some examples, refer to FIG. 5. The chip module 10 may further include a first connecting member 110. The first connecting member 110 may be disposed on the first heat dissipation member 17, and the first connecting member 110 may be located in the provided groove.

The groove may be provided, so that the first connecting member has high interface flexibility in a forming process. For example, in a process of manufacturing the spherical first connecting member, a molding material of the first connecting member may be placed inside the groove, and there is a gap between the molding material of the first connecting member and the second encapsulation member, so that the molding material of the first connecting member has high flexibility, which facilitates spherical forming of the first electrical connecting member, and improves a forming yield rate of the first electrical connecting member.

It should be noted that the first connecting member 110 may partially fill the groove, so that the first connecting member 110 maintains high interface flexibility in the forming process. For example, a vertical projection of the formed first connecting member 110 on the substrate 11 partially covers a vertical projection of the groove on the substrate 11. Refer to FIG. 5. There may be a gap 181 between an outer wall surface of the first connecting member 110 and the second encapsulation member 14, that is, a vertical projection of the first connecting member 110 on the first end of the first heat dissipation member 17 partially covers the exposed part of the first end of the first heat dissipation member 17, so that a part of the first heat dissipation member 17 can still be exposed from the surface that is of the second encapsulation member 14 and that faces away from the substrate 11.

Alternatively, the first connecting member 110 may fill the entire groove. For example, the vertical projection of the formed first connecting member 110 on the substrate 11 completely covers the vertical projection of the groove on the substrate 11, and the outer wall surface of the first connecting member 110 located inside the groove extends to the second encapsulation member 14, so that the vertical projection of the first connecting member 110 on the first end of the first heat dissipation member 17 can completely cover the exposed part of the first end of the first heat dissipation member 17, and the first heat dissipation member 17 is not exposed from the surface that is of the second encapsulation member 14 and that faces away from the substrate 11.

FIG. 6 is a diagram of assembling the chip module in FIG. 5 and a circuit board.

Refer to FIG. 6. When the first heat dissipation member 17 is assembled with and connected to the circuit board 20, the first heat dissipation member 17 may be secured to and assembled with the circuit board 20 through the first connecting member 110, to improve assembly stability of the chip module 10 and the circuit board 20. This can also transfer heat to the circuit board 20 for heat dissipation, thereby improving heat dissipation effect.

For example, an end that is of the first connecting member 110 and that faces away from the first heat dissipation member 17 may protrude from the surface that is of the second encapsulation member 14 and that faces away from the substrate 11, that is, the end that is of the first connecting member 110 and that faces away from the first heat dissipation member 17 is disposed to protrude from the second encapsulation member 14, to facilitate assembly of the first connecting member 110 and the circuit board 20.

In some examples, the first connecting member 110 may be a soldering member. For example, the first connecting member 110 may alternatively be a soldering ball, for example, may be a tin ball. The first connecting member 110 may be secured to the conductive member on the circuit board 20 through soldering.

In some examples, the first connecting member 110 may be electrically connected to the circuit board 20, and the first heat dissipation member 17 may be electrically connected to the chip through the substrate 11, so that the chip can be electrically connected to the circuit board 20 through the first heat dissipation member 17 and the first connecting member 110. For example, refer to FIG. 6. The substrate 11 may have a routing trace 111e, the fourth chip 12d located on the second surface 11b may be electrically connected to the first heat dissipation member 17 through the routing trace 111e, and the first heat dissipation member 17 may be electrically connected to the circuit board 20 through the first connecting member 110, so that the fourth chip 12d is electrically connected to the circuit board 20. For example, the fourth chip 12d may be grounded in this connection manner.

Certainly, in another example, the first heat dissipation member 17 may not be connected to the chip, and the first connecting member 110 may be connected to the circuit board 20 only for heat conduction, without an electrical connection.

Alternatively, in some examples, the first connecting member 110 may be another type of connecting structural member. For example, the first connecting member 110 may be an adhesive layer, a clamping member, a threaded fastener, or the like, so that the chip module 10 may be secured to the circuit board 20 through bonding, clamping, threaded fastening, or the like.

It should be noted that, in some examples, refer to FIG. 6. There may be a plurality of first connecting members 110 secured to the first heat dissipation member 17. For example, the plurality of first connecting members 110 may be disposed on the first heat dissipation member 17 in an array, and the plurality of first connecting members 110 may be spaced.

FIG. 7 is a diagram of a cross-sectional structure of still another chip module according to an embodiment of this application.

Alternatively, in some other examples, refer to FIG. 7. There may be one first connecting member 110.

The following describes an assembly relationship between the first chip 12a, the first heat dissipation member 17, and the substrate 11 by using an example in which the first heat dissipation member 17 covers at least the first region of the first chip 12a.

In some examples, as shown in FIG. 7, the first chip 12a may be disposed on the first surface 11a of the substrate 11.

A surface that is of the first chip 12a and that faces the substrate 11 has the first electrical connecting member 121a, a routing trace 111d of the substrate 11 may extend to the first surface 11a of the substrate 11, and the first electrical connecting member 121a of the first chip 12a may be electrically connected to the routing trace 111d through the soldering member 16, to implement an electrical connection between the first chip 12a and the substrate 11. Heat of the first chip 12a is transferred to the substrate 11 through the first electrical connecting member 121a, and the heat is dissipated through the first heat dissipation member 17. An end surface of an end that is of the first electrical connecting member 121a and that is connected to the substrate 11 forms the heat conduction region (for example, the first region) of the first chip 12a.

For example, the first heat dissipation member 17 may be secured to the second surface 11b of the substrate 11. For example, the second end of the first heat dissipation member 17 is secured to the second surface 11b of the substrate 11, so that the first chip 12a and the first heat dissipation member 17 are respectively located on the first surface 11a and the second surface 11b of the substrate 11. This results in a simple structural design. During manufacturing of the chip module 10, the first heat dissipation member 17 may also be disposed on the second surface 11b when the chip is disposed on the second surface 11b. This is fully compatible with an existing manufacturing process of a DSBGA packaged chip module in the related technology, without introducing any additional process, thereby helping reduce costs.

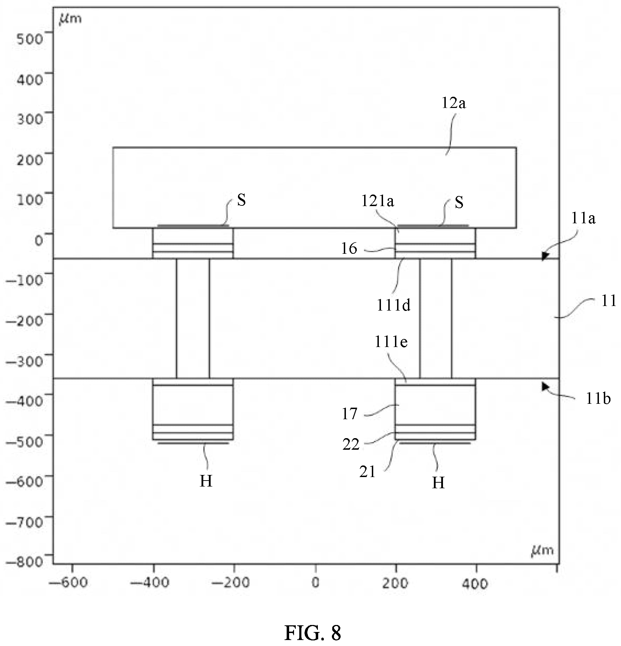

In this embodiment of this application, heat dissipation effect on the chip module 10 is simulated. FIG. 8 is a diagram of a junction-to-board thermal resistance model of a first chip in the chip module in FIG. 7.

Refer to FIG. 8. The first electrical connecting member 121a of the first chip 12a is connected to the routing trace 111d on the first surface 11a of the substrate 11 through the soldering member 16. For example, the first heat dissipation member 17 is secured to the conductive member 21 on the circuit board through soldering. There may be a soldering layer 22 between the first heat dissipation member 17 and the conductive member 21, and the routing trace 111e on the second surface 11b of the substrate 11 is connected to the conductive member 21 on the circuit board through the first heat dissipation member 17 and the soldering layer 22. A molding material of the first heat dissipation member 17 is copper.

A position of the first chip 12a relative to the heat conduction region may be used as a heat source S, and heat may be sequentially transferred from the first electrical connecting member 121a of the first chip 12a to the circuit board in the thickness direction, to form a constant-temperature surface H on the circuit board side.

A DSBGA packaged chip module in the related technology is used as a comparison group, and in the chip module in the comparison group, a layout position of a soldering ball may be a theoretical ideal position with optimal heat dissipation effect. For example, the soldering ball may be arranged beneath the heat conduction region of the first chip, the first electrical connecting member of the first chip is connected to the routing trace on the first surface of the substrate through the soldering member, and the routing trace on the second surface of the substrate is connected to the conductive member on the circuit board through the soldering ball and the soldering layer. The soldering ball is a tin ball. Table 1 shows a molding material and a thermal conductivity coefficient of each structural member in the foregoing model. The chip module 400 in the comparison group is the same as another structural design of the chip module 10 in this embodiment of this application.

Table 1 shows molding materials and thermal conductivity coefficients of a part of structural members in the foregoing model.

| Component | Material | Thermal conductivity coefficient |
|---|---|---|
| First chip | Silicon (silicon) | 130 W/(mK) |
| First electrical connecting member/First heat dissipation member/Routing trace/Conductive member | Copper (copper) | 400 W/(mK) |
| Soldering member/Soldering ball/Soldering layer | Tin alloy (Sn alloy) | 50 W/(mK) |
| Substrate | Resin (FR4 resin) | 0.3 W/(mK) |

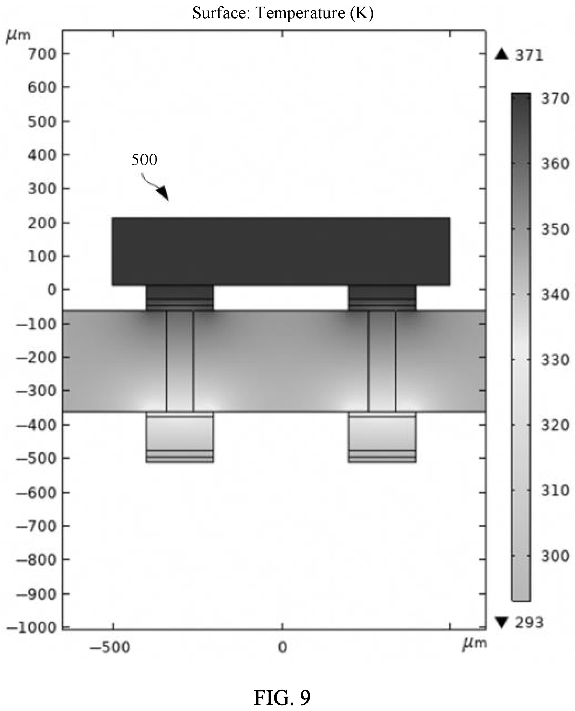

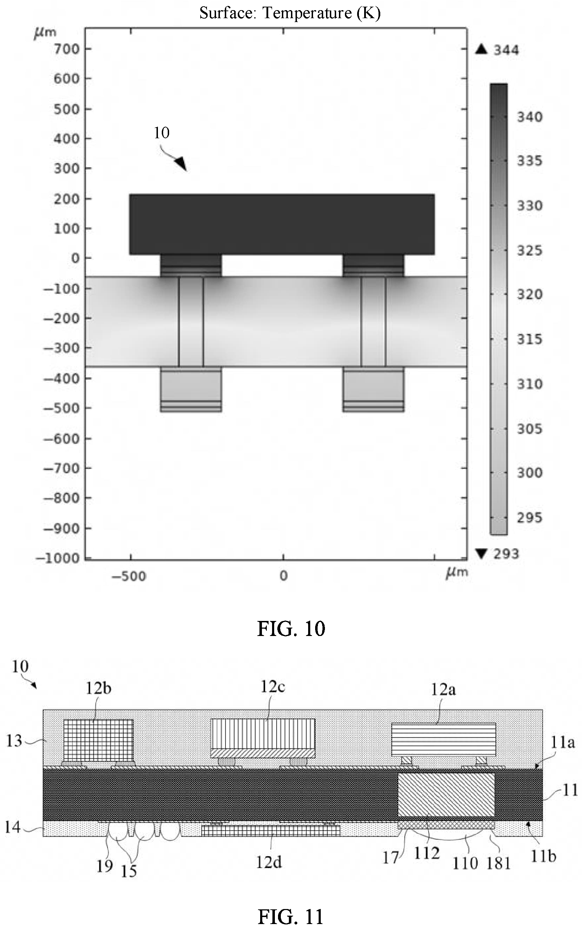

FIG. 9 is a diagram of simulation of heat conduction of a first chip in a ball grid array chip module in a related technology, and FIG. 10 is a diagram of simulation of heat conduction of the first chip in the chip module in FIG. 7.

With reference to FIG. 9 and FIG. 10, even in comparison with a theoretical ideal ball grid array chip module 500, in the chip module 10 in this embodiment of this application, the first heat dissipation member 17 made of metal copper is used to replace soldering balls, so that the vertical projection of the first heat dissipation member 17 covers at least a part of the vertical projection of the heat conduction region (for example, covers the first region) of the first chip 12a, and a temperature difference is reduced by 35%, thereby achieving more significant heat dissipation effect.

FIG. 11 is a diagram of a cross-sectional structure of yet another chip module according to an embodiment of this application.

In some examples, refer to FIG. 11. To further improve heat dissipation performance, the first heat dissipation member 17 is secured to the second surface 11b of the substrate 11, and a second heat dissipation member 112 may be further disposed on the substrate 11.

A molding material of the second heat dissipation member 112 may also be a material having a high thermal conductivity coefficient. The molding material of the second heat dissipation member 112 may be the same as the molding material of the first heat dissipation member 17. For the molding material, a shape, and the thermal conductivity coefficient of the second heat dissipation member 112, refer to the first heat dissipation member 17. Details are not described in this example.

The second heat dissipation member 112 may be located on a side that is of the first surface 11a and that faces the second surface 11b, and the second heat dissipation member 112 is located between the first surface 11a and the surface that is of the second encapsulation member 14 and that faces away from the substrate 11, that is, the second heat dissipation member 112 is not exposed from the first surface 11a. A vertical projection of the second heat dissipation member 112 on the substrate 11 may at least partially overlap the vertical projection of the first heat dissipation member 17 on the substrate 11, that is, the projection of the second heat dissipation member 112 on the substrate 11 in the x direction at least partially overlaps the projection of the first heat dissipation member 17 on the substrate 11 in the x direction. Thermal resistance on the heat dissipation path from the first chip 12a to the first heat dissipation member 17 is reduced, thereby further improving heat dissipation effect.

It should be noted that the vertical projections of the second heat dissipation member 112 and the first heat dissipation member 17 on the substrate 11 may completely overlap, or the vertical projections of the second heat dissipation member 112 and the first heat dissipation member 17 on the substrate 11 may partially overlap. For example, the vertical projection of the second heat dissipation member 112 on the substrate 11 may cover at least 50% of an area of the vertical projection of the first heat dissipation member 17 on the substrate 11, to ensure favorable heat dissipation effect.

In a possible implementation, refer to FIG. 11. The second heat dissipation member 112 may be located inside the substrate 11, that is, the second heat dissipation member 112 is located between the first surface 11a and the second surface 11b, and the second heat dissipation member 112 is not exposed from the first surface 11a and the second surface 11b. This improves the heat dissipation effect and simplifies the structural design.

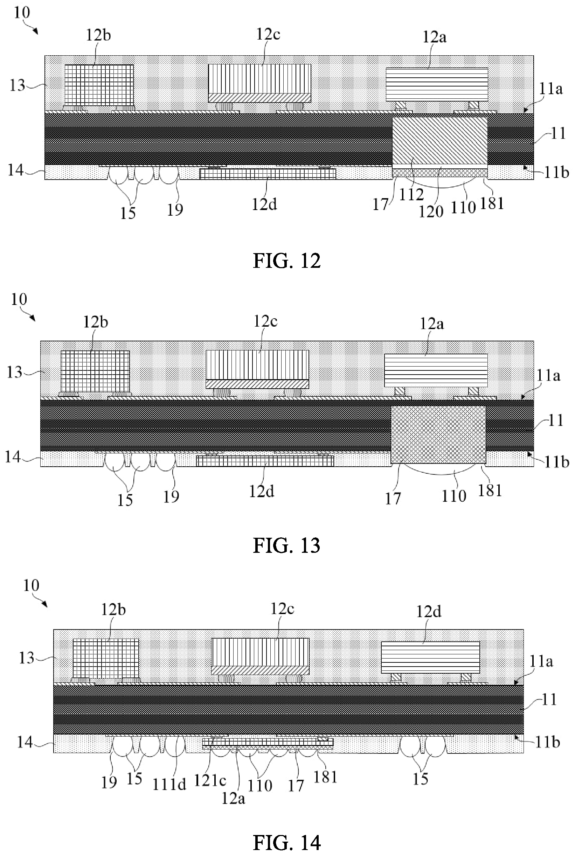

FIG. 12 is a diagram of a cross-sectional structure of still another chip module according to an embodiment of this application.

In another possible implementation, refer to FIG. 12. One end of the second heat dissipation member 112 may be located inside the substrate 11, the other end of the second heat dissipation member 112 may extend into the second encapsulation member 14 in the thickness direction, and the second end of the first heat dissipation member 17 may be secured to the other end of the second heat dissipation member 112, so that the first heat dissipation member 17 is secured to the second surface 11b. This helps increases a thickness of the second heat dissipation member 112, further reduces thermal resistance, and enriches securing and assembling manners for the first heat dissipation member 17 and the second surface 11b of the substrate 11, thereby providing greater structural design flexibility.

For example, an end surface of the other end of the second heat dissipation member 112 may extend to a side that is of the substrate 11 and that faces away from the first surface 11a, and the end surface of the other end of the second heat dissipation member 112 may be flush with the side that is of the substrate 11 and that faces away from the first surface 11a, so that the end surface of the other end of the second heat dissipation member 112 is used to form a part of the second surface 11b, and the first heat dissipation member 17 is secured to the end surface of the other end of the second heat dissipation member 112.

For example, to implement securing of the first heat dissipation member 17 to the second heat dissipation member 112, the chip module 10 may further include a second connecting member 120, and the first heat dissipation member 17 may be secured to, through the second connecting member 120, an end surface of an end that is of the second heat dissipation member 112 and that faces away from the first surface 11a.

The second connecting member 120 may alternatively be a soldering member. For example, the second connecting member 120 may be a soldering ball, a soldering pad, or the like, so that the first heat dissipation member 17 may be secured to an end surface of the second heat dissipation member 112 through soldering.

Alternatively, the second connecting member 120 may be another type of connecting structural member. For example, the second connecting member 120 may be an adhesive layer, a clamping member, a threaded fastener, or the like, so that the first heat dissipation member 17 may be secured to the end surface of the second heat dissipation member 112 through bonding, clamping, threaded fastening, or the like.

FIG. 13 is a diagram of a cross-sectional structure of still another chip module according to an embodiment of this application.

Alternatively, in some other examples, refer to FIG. 13. The second end of the first heat dissipation member 17 may extend into and be secured inside the substrate 11, that is, the first heat dissipation member 17 is inserted into the substrate 11, a portion of the first heat dissipation member 17 is located inside the substrate 11, and another portion of the first heat dissipation member 17 is located inside the second encapsulation member 14. The second end of the first heat dissipation member 17 extends into and is secured inside the substrate 11. This helps reduce a quantity of heat dissipation members disposed on the substrate 11 while further reducing thermal resistance and improving heat dissipation effect, simplifies a structural design and a forming process, and contributes to cost reduction.

FIG. 14 is a diagram of a cross-sectional structure of still another chip module according to an embodiment of this application.

Alternatively, in some other examples, refer to FIG. 14. The first chip 12a may be disposed on the second surface 11b of the substrate 11.

A surface that is of the first chip 12a and that faces the substrate 11 has the second electrical connecting member 121c. The routing trace 111d of the substrate 11 may be located on the second surface 11b of the substrate 11. The first chip 12a may be electrically connected to the routing trace 111d of the substrate 11 through the second electrical connecting member 121c, and then electrically connected to the conductive member 15 through the routing trace 111d.

Correspondingly, the second electrical connecting member 121c of the first chip 12a may alternatively be electrically connected to the routing trace 111d through the soldering member 16.

The first heat dissipation member 17 may be secured to a side that is of the first chip 12a and that faces away from the substrate 11, heat generated by the first chip 12a is transferred to the first heat dissipation member 17 to implement heat dissipation, and the heat conduction region of the first chip 12a is formed on the surface that is of the first chip 12a and that faces the first heat dissipation member 17, thereby further shortening the heat dissipation path, reducing the thermal resistance, and improving heat dissipation efficiency.

For example, the first heat dissipation member 17 may be formed by a back metal layer of the first chip 12a. Layout manners of the first chip 12a and the first heat dissipation member 17 are enriched, and layout flexibility is improved.

Certainly, in some other examples, the first heat dissipation member 17 may alternatively be a heat dissipation structural member additionally disposed on the first chip 12a.

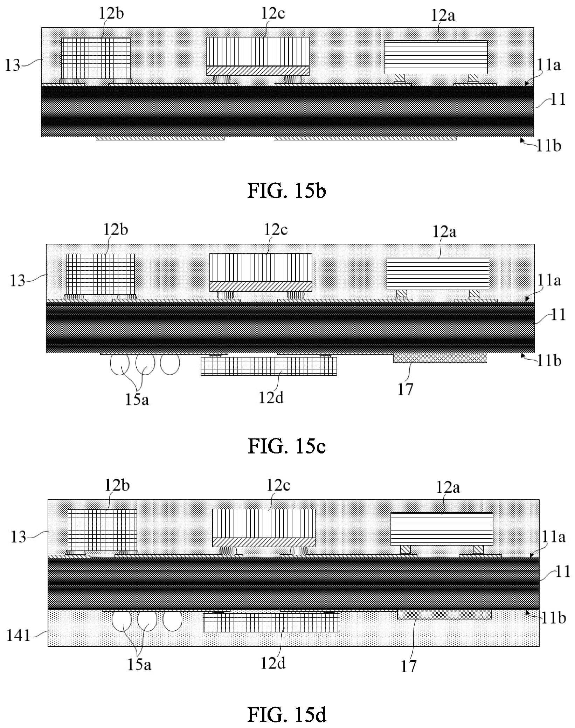

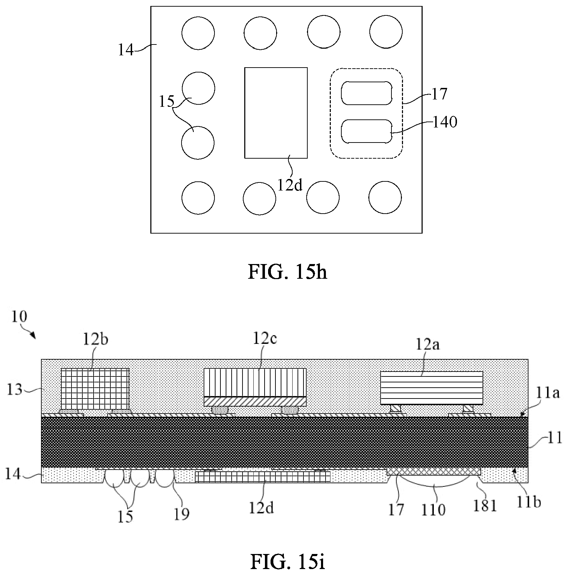

An embodiment of this application further provides a chip module manufacturing method. FIG. 15 is a schematic flowchart of a chip module manufacturing method according to an embodiment of this application. Refer to FIG. 15. The foregoing chip module 10 can be manufactured by using the manufacturing method.

The manufacturing method includes:
S101: Provide a substrate, a first heat dissipation member, and a plurality of chips.

FIG. 15a is a diagram in which a part of the chips are assembled on the substrate in the chip module according to an embodiment of this application.

Refer to FIG. 15a. The substrate 11 has a first surface 11a and a second surface 11b that face away from each other in a thickness direction, and the substrate 11 has routing traces. The routing trace may extend to the first surface 11a and the second surface 11b of the substrate 11. For example, a routing trace 111a extends to the first surface 11a of the substrate 11, and a routing trace 111c is located on the second surface 11b of the substrate 11.

For specific structures of the substrate 11, the routing traces, the chip, and the first heat dissipation member 17, refer to the foregoing description. Details are not described in this example again.

S102: Dispose a part of the plurality of chips on the first surface, and form a first encapsulation member on the first surface.

As shown in FIG. 15a, a part of the chips are assembled on the first surface 11a of the substrate 11. For example, a first chip 12a is secured to the first surface 11a of the substrate 11. For example, the first chip 12a, a second chip 12b, and a third chip 12c are assembled on and secured to the first surface 11a, and the first chip 12a, the second chip 12b, and the third chip 12c are correspondingly electrically connected to the routing traces of the substrate 11.

The chip may be secured to the first surface 11a by using a surface mounted technology (surface mounted technology, SMT for short), or the chip may be secured to the first surface 11a through soldering, bonding, or the like.

FIG. 15b is a diagram in which a first encapsulation member is formed on the substrate in the chip module according to an embodiment of this application.

Refer to FIG. 15b. A first encapsulation member 13 is formed on the first surface 11a of the substrate 11. The first encapsulation member 13 may cover the first surface 11a, and the chip located on the first surface 11a is at least partially packaged and encapsulated in the first encapsulation member 13, to implement plastic packaging of the chip on the first surface 11a. For example, the first chip 12a, the second chip 12b, and the third chip 12c may be encapsulated and packaged in the first encapsulation member 13.

S103: Dispose the other part of the plurality of chips on the second surface, where at least a first end of the first heat dissipation member is located on the second surface.

FIG. 15c is a diagram in which the chip and a soldering joint member are assembled on the substrate in the chip module according to an embodiment of this application.

Refer to FIG. 15c. The other part of chips are assembled on the second surface 11b of the substrate 11. For example, a fourth chip 12d is assembled on and secured to the second surface 11b, and the fourth chip 12d is correspondingly electrically connected to the routing trace of the substrate 11.

The chip may alternatively be secured to the second surface 11b through SMT mounting, soldering, bonding, or the like.

For example, before or after the chip is disposed on the second surface 11b, at least the first end of the first heat dissipation member may be further located on the second surface. Refer to FIG. 15c. For example, a second end of the first heat dissipation member 17 is secured to the second surface 11b of the substrate 11. Before or after the chip is disposed on the second surface 11b, the first heat dissipation member 17 may also be secured to the second surface 11b. In addition, a vertical projection of the first heat dissipation member 17 on the substrate 11 at least partially covers a vertical projection of the heat conduction region of the first chip 12a on the substrate 11.

S104: Form an encapsulation layer on the second surface.

FIG. 15d is a diagram in which the encapsulation layer is formed on the second surface of the substrate in the chip module according to an embodiment of this application.

Refer to FIG. 15d. The encapsulation layer 141 covers the second surface 11b, and the encapsulation layer 141 encapsulates the chips and the first heat dissipation member 17 that are located on the second surface 11b. For example, the fourth chip 12d and the first heat dissipation member 17 are encapsulated in the encapsulation layer 141.

S105: Thin the encapsulation layer to form a thin encapsulation layer.

For example, the encapsulation layer may be thinned through grinding and removal.

FIG. 15e is a diagram of a thinned encapsulation layer in the chip module according to an embodiment of this application.

A part of the encapsulation layer may be removed to thin the encapsulation layer. Refer to FIG. 15e. A part of the encapsulation layer that is not removed forms the thinned encapsulation layer 141a, and the thinned encapsulation layer 141a is configured to form a second encapsulation member. After the encapsulation layer is thinned to form the thinned encapsulation layer 141a, the first end of the first heat dissipation member 17 is encapsulated in the thinned encapsulation layer 141a. For example, there may be a preset distance h between an end surface of the first end of the first heat dissipation member 17 and a surface that is of the thinned encapsulation layer 141a and that faces away from the substrate 11. After thinning, the first heat dissipation member 17 is not exposed on the surface that is of the thinned encapsulation layer 141a and that faces away from the substrate 11. That is, in a process of thinning the encapsulation layer, a grinding removal depth (a thickness in an x direction) does not reach a position of the first heat dissipation member 17 (the end surface of the first end), and the first heat dissipation member 17 is not thinned while the encapsulation layer is thinned. This avoids problems such as delamination, cracks, or separation at a junction between a circumferential side wall of the first heat dissipation member 17 and the encapsulation layer in the grinding and thinning process, thereby improving grindability and reliability of the encapsulation layer, improving a yield rate, and avoiding a problem like a short circuit.

S106: Process the thinned encapsulation layer to form the second encapsulation member, to enable an end surface of an end of the first heat dissipation member to be recessed, in the thickness direction, relative to a surface that is of the second encapsulation member and that faces away from the substrate.

For example, the thinned encapsulation layer may be processed in a manner such as grooving on the thin encapsulation layer, or cutting off a part that is of the thinned encapsulation layer and that is opposite to the end of the first heat dissipation member, to form the second encapsulation member, so that the end surface of the first end of the first heat dissipation member is recessed inward relative to the surface that is of the second encapsulation member and that faces away from the substrate, that is, the end surface of the first end of the first heat dissipation member is recessed, in the thickness direction and toward the first encapsulation member, relative to the surface that is of the second encapsulation member and that faces away from the substrate.

For example, the processing the thinned encapsulation layer to form the second encapsulation member in step S106 may include: providing a groove on the surface that is of the thinned encapsulation layer and that faces away from the substrate, to form the second encapsulation member.

For example, the groove may be provided, through laser grooving, on the surface that is of the thinned encapsulation layer and that faces away from the substrate 11, to form the second encapsulation member.

FIG. 15f is a diagram in which the second encapsulation member is formed in the chip module according to an embodiment of this application.

Refer to FIG. 15f. A surface that is of the formed second encapsulation member 14 and that faces away from the substrate 11 has a groove 18. The groove 18 may be located on a side that is of the first heat dissipation member 17 and that faces away from the substrate 11. The groove 18 extends to the first end of the first heat dissipation member 17, so that the end surface of the first end of the first heat dissipation member 17 is recessed, in the thickness direction, relative to the surface that is of the second encapsulation member 14 and that faces away from the substrate 11. It is ensured that in the thickness direction, the preset distance h is still reserved between the end surface of the first end of the first heat dissipation member 17 and the surface that is of the second encapsulation member 14 and that faces away from the substrate 11.

To form a conductive member of the chip module, so as to implement an electrical connection between the chip module and an external circuit board, before the forming the encapsulation layer on the second surface in step S104, the method further includes: forming a plurality of spaced soldering joint members on the second surface.

For example, a plurality of tin balls may be formed on the second surface through bumping as a plurality of soldering joint members 15a (with reference to FIG. 15c), and the plurality of soldering joint members 15a are spaced. The soldering joint member 15a may be correspondingly electrically connected to a routing trace on the second surface 11b, so that the chip is electrically connected to the corresponding soldering joint member.

The forming the encapsulation layer on the second surface in step S104 includes: encapsulating the soldering joint member by using the encapsulation layer (with reference to FIG. 15d).

After the forming an encapsulation layer on the second surface in step S104, the method further includes: thinning the soldering joint member to form a conductive member.

Synchronous thinning of the encapsulation layer and the soldering joint member may be implemented through grinding and removal (with reference to FIG. 15d and FIG. 15e). An unremoved thinned encapsulation layer 141a is configured to form the second encapsulation member 14, and an unremoved part of the soldering joint member is configured to form a conductive member 15, to ensure that an end that is of the conductive member 15 and that faces away from the substrate 11 is exposed on the surface that is of the second encapsulation member 14 and that faces away from the substrate 11, so that the conductive member 15 is exposed from the second encapsulation member 14.

For example, the thinning the soldering joint member to form the conductive member may include the following steps.

S1041: Thin the soldering joint member to form a transition soldering joint.

A part that is not removed after the soldering joint member is thinned forms a transition soldering joint 15b (with reference to FIG. 15f).

S1042: Form a notch structure on the surface that is of the thinned encapsulation layer and that faces away from the substrate.

For example, a notch structure 19a may be formed on the surface that is of the thinned encapsulation layer and that faces away from the substrate 11 through laser grooving or the like, and the notch structure 19a may be disposed around the transition soldering joint 15b, so that after the thinned encapsulation layer forms the second encapsulation member, the surface that is of the second encapsulation member 14 and that faces away from the substrate 11 has the notch structure 19a (with reference to FIG. 15f).

S1043: Dispose a first solder structure on the transition soldering joint, and perform reflow processing on the transition soldering joint and the first solder structure to form the conductive member.

FIG. 15g is a diagram in which the first solder structure and a second solder structure are disposed on the transition soldering joint in the chip module according to an embodiment of this application.

Refer to FIG. 15g. The first solder structure 130 is disposed on the transition soldering joint 15b. The first solder structure 130 may be solder paste, and the first solder structure 130 may alternatively be secured to the transition soldering joint 15b through printing or the like, so that after reflow processing, the transition soldering joint 15b and the first solder structure 130 form the conductive member 15 (with reference to FIG. 15i).

The notch structure 19a may increase interface flexibility of the transition soldering joint 15b and the first solder structure 130, thereby facilitating reflow forming of the conductive member 15, and especially facilitating forming of the spherical conductive member.

Certainly, in some examples, step S1042 may alternatively be omitted, that is, the notch structure 19a does not need to be formed on the surface that is of the second encapsulation member and that faces away from the substrate.

In some examples, the conductive member 15 formed through reflow may partially fill the notch structure 19a. For example, a vertical projection of the conductive member 15 on the substrate 11 partially covers a vertical projection of the notch structure 19a on the substrate 11, so that there is a gap 19 between an outer wall surface of the conductive member 15 and the second encapsulation member 14 (with reference to FIG. 15i).

Alternatively, in some examples, the formed conductive member 15 may completely fill the notch structure 19a. For example, the vertical projection of the conductive member 15 on the substrate 11 completely covers the vertical projection of the notch structure 19a on the substrate 11, so that the outer wall surface of the conductive member 15 extends to the second encapsulation member 14.

It may be understood that, controlling a quantity of first solder structures 130 may implement controlling of a thickness size and the like of the conductive member 15 on which reflow is performed, so that the end that is of the conductive member 15 that faces away from the substrate 11 may be disposed to protrude from the surface that is of the second encapsulation member 14 and that faces away from the substrate 11.

In some examples, a part of the first end of the first heat dissipation member 17 may be exposed from the second encapsulation member 14 through the provided groove 18 (with reference to FIG. 15f), so that heat can be transferred to the outside of the chip module 10 through the first heat dissipation member 17.

Alternatively, in some examples, the chip module may further include a first connecting member. The first connecting member may be secured to the first heat dissipation member 17, so that the first heat dissipation member 17 can be connected to a structural member like a circuit board through the first connecting member, to transfer heat to the outside of the chip module through the first heat dissipation member 17 and the first connecting member. For a specific structure of the first connecting member, refer to the foregoing description. Details are not described in this example.

To form the first connecting member, after the providing the groove on the surface that is of the thinned encapsulation layer and that faces away from the substrate to form the second encapsulation member, the manufacturing method may further include the following steps.

S107: Dispose the second solder structure on the first end of the first heat dissipation member.

Refer to FIG. 15g. The second solder structure 140 is disposed on the first end of the first heat dissipation member 17, and the second solder structure 140 may be located inside the groove 18. For example, the groove 18 may be disposed around the second solder structure 140. The groove 18 may improve interface flexibility of the second solder structure 140, and facilitate reflow forming of the first connecting member.

FIG. 15h is a bottom view in which the first solder structure and the second solder structure are disposed on the first heat dissipation member in the chip module according to an embodiment of this application.

With reference to FIG. 15h, the second solder structure 140 may be secured to the end surface of the first end of the first heat dissipation member 17. For example, the second solder structure 140 may be solder paste, and the second solder structure 140 may be secured to the end surface of the first end of the first heat dissipation member 17 through printing or the like.

S108: Perform reflow processing on the second solder structure to form the first connecting member.

For example, after reflow processing is performed on the solder paste, a soldering ball may be formed as the first connecting member.

FIG. 15i is a diagram in which reflow is performed on the second solder structure in the chip module according to an embodiment of this application. Refer to FIG. 15i. The first connecting member 110 is formed on the first heat dissipation member 17, so that the first heat dissipation member 17 is assembled with and connected to the external circuit board through the first connecting member 110.

In some examples, the first connecting member 110 formed through reflow may partially fill the groove. For example, a vertical projection of the first connecting member 110 on the substrate 11 partially covers a vertical projection of the groove on the substrate 11. Refer to FIG. 15i. There is a gap 181 between the first connecting member 110 and the second encapsulation member 14, and a part of the first end of the first heat dissipation member 17 may still be exposed from the surface that is of the second encapsulation member 14 and that faces away from the substrate 11.

Alternatively, in some examples, the formed first connecting member 110 may fill the entire groove. For example, the vertical projection of the first connecting member 110 on the substrate 11 completely covers the vertical projection of the groove on the substrate 11, so that an outer wall surface of the first connecting member 110 extends to the second encapsulation member 14, and the first heat dissipation member 17 is not exposed from the surface that is of the second encapsulation member 14 and that faces away from the substrate 11.

Correspondingly, controlling a quantity of second solder structures 140 can implement controlling of a thickness size and the like of the first connecting member 110 on which reflow is performed, or the end that is of the first connecting member 110 and that faces away from the first heat dissipation member 17 may be disposed to protrude from the surface that is of the second encapsulation member 14 and that faces away from the substrate 11.

It should be noted that, to simplify a forming process, the notch structure and the groove may be synchronously formed, and printing forming, reflow processing, and the like of the first solder structure and the second solder structure may also be synchronously formed.

For example, when the groove is provided on the thinned encapsulation layer through laser grooving or the like, the notch structure may be synchronously provided on the thinned encapsulation layer in a same manner, so that the surface that is of the formed second encapsulation member 14 and that faces away from the substrate 11 has the groove 18 and the notch structure 19a (with reference to FIG. 15f).

For example, when the first solder structure 130 is disposed on the transition soldering joint through printing or the like, the second solder structure 140 may also be synchronously disposed on the first heat dissipation member 17 in a same manner (with reference to FIG. 15g).

When reflow processing is performed on the first solder structure 130 and the transition soldering joint, reflow processing on the second solder structure 140 may also be synchronously completed in a same manner, to synchronously form the conductive member 15 and the first connecting member 110 (with reference to FIG. 15i).

In some examples, the first chip is disposed on the first surface of the substrate, and a surface that is of the first chip and that faces the substrate has the first electrical connecting member.

The disposing the part of the plurality of chips on the first surface in step S102 may include: assembling the first chip on the first surface, and electrically connecting the first chip to the substrate through the first electrical connecting member.

For example, the first electrical connecting member may be soldered and secured to the routing trace of the substrate through soldering manner to implement an electrical connection. In this way, the first chip is assembled on the first surface of the substrate in the foregoing manner, and the electrical connection between the first chip and the substrate is implemented. Heat of the first chip may be transferred to the substrate through the first electrical connecting member, and an end surface of an end that is of the first electrical connecting member and that is connected to the substrate forms a heat conduction region of the first chip.

For example, the providing the substrate and the first heat dissipation member in step S101 may include S1011: Secure a second end of the first heat dissipation member to the second surface. In the method, the chip module 10 whose layout manner is that the first chip 12a is located on the first surface 11a and the first heat dissipation member 17 is located on the second surface 11b can be obtained (with reference to FIG. 7).

The second end of the first heat dissipation member may be mounted on the second surface of the substrate through an SMT. Alternatively, in some examples, the second end of the first heat dissipation member may be secured to the second surface in another manner, for example, may be attached to the second surface through bonding.

In some examples, the substrate may further have a second heat dissipation member, and the second heat dissipation member may be formed on the substrate when the substrate is formed, that is, the second heat dissipation member is integrally formed in a substrate forming process.

Alternatively, the second heat dissipation member and the substrate may be assembled together after the second heat dissipation member and the substrate are separately formed.

The securing the second end of the first heat dissipation member to the second surface in step S1011 may include: enabling a vertical projection of the first heat dissipation member on the substrate to at least partially overlap a vertical projection of the second heat dissipation member on the substrate, so that heat dissipation effect is further improved through the second heat dissipation member.

For example, the second heat dissipation member may be secured inside the substrate, that is, the second heat dissipation member is located between the first surface and the second surface, and the first heat dissipation member is assembled on the second surface. For an assembly manner, refer to step S1011. In the method, the chip module 10 whose layout manner is that the first chip 12a is located on the first surface 11a, the first heat dissipation member 17 is located on the second surface 11b, and the second heat dissipation member 112 is disposed inside the substrate 11 can be obtained (with reference to FIG. 11).

Alternatively, in some examples, one end of the second heat dissipation member is located inside the substrate, and the other end of the second heat dissipation member may extend toward the second encapsulation member in the thickness direction. For example, an end surface of the other end of the second heat dissipation member extends to a side that is of the substrate and that faces away from the first surface, and the end surface of the other end of the second heat dissipation member may form a part of the second surface.

The foregoing step S1011 of securing the second end of the first heat dissipation member to the second surface may include: forming a second connecting member on the other end of the second heat dissipation member, to enable the second end of the first heat dissipation member to be secured to the other end of the second heat dissipation member through the second connecting member, to implement securing and assembling of the first heat dissipation member on the second surface of the substrate. In the method, the chip module 10 whose layout manner is that the first chip 12a is located on the first surface 11a, the first heat dissipation member 17 is located on the second surface 11b, one end of the second heat dissipation member 112 is located inside the substrate 11, and the other end is secured to the first heat dissipation member can be obtained (with reference to FIG. 12).

In some other examples, step S101 of providing the substrate and the first heat dissipation member may include S1012: Secure the second end of the first heat dissipation member inside the substrate. In the method, the chip module 10 whose layout manner is that the first chip 12a is located on the first surface 11a, and the first heat dissipation member 17 is partially secured inside the substrate 11 can be obtained (with reference to FIG. 13).

For example, the first heat dissipation member may be formed on the substrate when the substrate is formed, that is, in a substrate forming process, the substrate on which the first heat dissipation member is inserted is integrally formed.

Alternatively, the first heat dissipation member may be secured to the substrate in another manner. For example, the first heat dissipation member may be inserted into the substrate through bonding, clamping, or interference fit.

In some other examples, the first chip may be disposed on the second surface of the substrate, and the surface that is of the first chip and that faces the substrate has the second electrical connecting member.

The disposing the other part of the plurality of chips on the second surface in step S103 may include the following steps.

S1031: Dispose the first chip on the second surface, and electrically connect the first chip to the substrate through the second electrical connecting member.

For example, the second electrical connecting member may alternatively be soldered and secured to the routing trace of the substrate through soldering to implement an electrical connection, so that the first chip is assembled on the second surface of the substrate in the foregoing manner, and the first chip is electrically connected to the substrate.

S1032: Secure the first heat dissipation member to a surface that is of the first chip and that faces away from the substrate.

Heat generated by the first chip may be directly dissipated through the first heat dissipation member, and a heat conduction region is formed on a surface that is of the first chip and that faces away from the first heat dissipation member.

For example, the first heat dissipation member may be a back metal layer on the first chip, and the first heat dissipation member may be secured to the surface that is of the first chip and that faces away from the substrate through SMT mounting, bonding, printing, or the like. In the foregoing method, the chip module 10 whose layout manner is that the first chip 12a is located on the second surface 11b, and the first heat dissipation member 17 is located on the first chip 12a can be obtained (with reference to FIG. 14).

In the descriptions of embodiments of this application, it should be noted that, unless otherwise clearly specified and limited, the term "installed", "connected", or "connection" should be understood in a broad sense, for example, may be a secured connection, or may be an indirect connection through an intermediate medium, or may be internal communication between two elements or an interaction relationship between two elements. A person of ordinary skill in the art may understand specific meanings of the foregoing terms in embodiments of this application based on specific cases. The terms such as "first", "second", "third", "fourth", and the like (if any) are intended to distinguish between similar objects but do not necessarily indicate a specific order or sequence.

Finally, it should be noted that the foregoing embodiments are merely used to describe the technical solutions in embodiments of this application, but not to limit the technical solutions. Although embodiments of this application are described in detail with reference to the foregoing embodiments, a person of ordinary skill in the art should understand that the technical solutions recorded in the foregoing embodiments may still be modified, or a part or all of technical features thereof may be equivalently replaced. However, these modifications or replacements do not depart from the scope of the technical solutions in embodiments of this application.

## Claims

1. A chip module, comprising:
a substrate, wherein the substrate has a first surface and a second surface that face away from each other in a thickness direction;
a first encapsulation member, wherein the first encapsulation member is disposed on the first surface;
a second encapsulation member, wherein the second encapsulation member is disposed on the second surface;
a plurality of chips, wherein the plurality of chips are separately disposed on the first surface and the second surface, and the chip is at least partially encapsulated in the first encapsulation member or the second encapsulation member, the plurality of chips comprise a first chip, and the first chip has a heat conduction region for implementing heat conduction contact; and
a first heat dissipation member, wherein the first heat dissipation member is located between the first surface and a side that is of the second encapsulation member and that faces away from the substrate, at least a first end of the first heat dissipation member is located inside the second encapsulation member, and a vertical projection of the first heat dissipation member on the substrate at least partially covers a vertical projection of the heat conduction region on the substrate, wherein
an end surface of the first end of the first heat dissipation member is recessed, in the thickness direction, relative to a surface that is of the second encapsulation member and that faces away from the substrate, and a preset distance is provided between the end surface of the first end and the surface that is of the second encapsulation member and that faces away from the substrate.

2. The chip module according to claim 1, wherein the preset distance is from 10 µm to 20 µm.

3. The chip module according to claim 1 or 2, wherein there are a plurality of heat conduction regions, the plurality of heat conduction regions comprise at least a first region, and the first region is a region with a largest cross-sectional area in the plurality of heat conduction regions; and
the vertical projection of the first heat dissipation member on the substrate at least partially covers a vertical projection of the first region on the substrate.

4. The chip module according to claim 3, wherein the vertical projection of the first heat dissipation member on the substrate covers at least 50% of an area of the vertical projection of the first region on the substrate.

5. The chip module according to any one of claims 1 to 4, wherein the vertical projection of the first heat dissipation member on the substrate covers at least 50% of an area of a vertical projection of the first chip on the substrate.

6. The chip module according to claim 5, wherein the vertical projection of the first heat dissipation member on the substrate completely covers the vertical projection of the first chip on the substrate.

7. The chip module according to any one of claims 1 to 6, further comprising a plurality of spaced conductive members, wherein the conductive member is secured to the second surface, and the conductive member is electrically connected to the chip through the substrate; and
a part of the conductive member is located inside the second encapsulation member, and an end that is of the conductive member and that faces away from the substrate is exposed on the surface that is of the second encapsulation member and that faces away from the substrate.

8. The chip module according to claim 7, wherein a cross-sectional area of the first heat dissipation member is greater than a cross-sectional area of one of the conductive members.

9. The chip module according to claim 8, wherein the cross-sectional area of the first heat dissipation member is greater than π*(D/2)², and a range of D is from 200 µm to 300 µm.

10. The chip module according to any one of claims 1 to 9, wherein a thermal conductivity coefficient of the first heat dissipation member is greater than 100 W/mK.

11. The chip module according to any one of claims 1 to 10, wherein a thickness of the first heat dissipation member is greater than 30 µm.

12. The chip module according to any one of claims 1 to 11, wherein the surface that is of the second encapsulation member and that faces away from the substrate has a groove, and the groove extends to the first end of the first heat dissipation member, to expose a part of the first end.

13. The chip module according to any one of claims 1 to 11, further comprising a first connecting member, wherein the first connecting member is secured to the first end of the first heat dissipation member; and
an end that is of the first connecting member and that faces away from the first heat dissipation member is disposed to protrude from the surface that is of the second encapsulation member and that faces away from the substrate.

14. The chip module according to claim 13, wherein there is a gap between the first connecting member and the second encapsulation member.

15. The chip module according to any one of claims 7 to 9, wherein the end that is of the conductive member and that faces away from the substrate is disposed to protrude from the surface that is of the second encapsulation member and that faces away from the substrate.

16. The chip module according to claim 15, wherein there is a gap between the conductive member and the second encapsulation member.

17. The chip module according to any one of claims 1 to 16, wherein the first chip is disposed on the first surface, a surface that is of the first chip and that faces the substrate has a first electrical connecting member, and the first chip is electrically connected to the substrate through the first electrical connecting member; and
an end surface of an end that is of the first electrical connecting member and that is connected to the substrate forms the heat conduction region.

18. The chip module according to claim 17, wherein in the thickness direction, the first heat dissipation member further comprises a second end opposite to the first end, and the second end of the first heat dissipation member is secured to the second surface.

19. The chip module according to claim 18, wherein the substrate has a second heat dissipation member, and vertical projections of the second heat dissipation member and the first heat dissipation member on the substrate at least partially overlap.

20. The chip module according to claim 19, wherein the second heat dissipation member is located inside the substrate.

21. The chip module according to claim 19, wherein one end of the second heat dissipation member is located inside the substrate, the other end of the second heat dissipation member extends into the second encapsulation member in the thickness direction, and the second end of the first heat dissipation member is secured to the other end of the second heat dissipation member.

22. The chip module according to claim 17, wherein in the thickness direction, the first heat dissipation member further comprises a second end opposite to the first end, and the second end is secured inside the substrate.

23. The chip module according to any one of claims 1 to 16, wherein the first chip is disposed on the second surface, a surface that is of the first chip and that faces the substrate has a second electrical connecting member, and the first chip is electrically connected to the substrate through the second electrical connecting member; and
the first heat dissipation member is secured to a surface that is of the first chip and that faces away from the substrate, and a surface that is of the first chip and that faces the first heat dissipation member forms the heat conduction region.

24. A chip module manufacturing method, comprising:
providing a substrate, a first heat dissipation member, and a plurality of chips, wherein the substrate comprises a first surface and a second surface that face away from each other in a thickness direction, the plurality of chips comprise a first chip, and the first chip has a heat conduction region for implementing heat conduction contact;
disposing a part of the plurality of chips on the first surface, and forming a first encapsulation member on the first surface, wherein the chip located on the first surface is at least partially encapsulated in the first encapsulation member;
disposing the other part of the plurality of chips on the second surface, wherein at least a first end of the first heat dissipation member is located on the second surface, and a vertical projection of the first heat dissipation member on the substrate at least partially covers a vertical projection of the heat conduction region of the first chip on the substrate;
forming an encapsulation layer on the second surface, wherein the encapsulation layer encapsulates the chips and the first heat dissipation member that are located on the second surface;
thinning the encapsulation layer to form a thinned encapsulation layer, wherein the first end of the first heat dissipation member is encapsulated in the thin encapsulation layer; and
processing the thinned encapsulation layer to form a second encapsulation member, to enable an end surface of the first end of the first heat dissipation member to be recessed, in the thickness direction, relative to a surface that is of the second encapsulation member and that faces away from the substrate, wherein the chip located on the second surface is at least partially encapsulated in the second encapsulation member, the first heat dissipation member is located between the first surface and the surface that is of the second encapsulation member and that faces away from the substrate, and in the thickness direction, a preset distance is provided between the end surface of the first end of the first heat dissipation member and the surface that is of the second encapsulation member and that faces away from the substrate.

25. The manufacturing method according to claim 24, wherein before the forming the encapsulation layer on the second surface, the method further comprises: forming a plurality of spaced soldering joint members on the second surface, wherein the soldering joint members are electrically connected to the chip through the substrate;
the forming the encapsulation layer on the second surface further comprises: encapsulating the soldering joint member by using the encapsulation layer; and
after the forming the encapsulation layer on the second surface, the method further comprises: thinning the soldering joint member to form a conductive member, wherein an end that is of the conductive member and that faces away from the substrate is exposed on the surface that is of the second encapsulation member and that faces away from the substrate.

26. The manufacturing method according to claim 25, wherein the thinning the soldering joint member to form the conductive member comprises:
thinning the soldering joint member to form a transition soldering joint;
forming a notch structure on a surface that is of the thinned encapsulation layer and that faces away from the substrate, wherein the notch structure is disposed around the transition soldering joint; and
disposing a first solder structure on the transition soldering joint, and performing reflow processing on the transition soldering joint and the first solder structure to form the conductive member, wherein the end that is of the conductive member and that faces away from the substrate is disposed to protrude from the surface that is of the second encapsulation member and that faces away from the substrate.

27. The manufacturing method according to any one of claims 24 to 26, wherein the processing the thinned encapsulation layer to form the second encapsulation member comprises:
providing a groove on the surface that is of the thinned encapsulation layer and that faces away from the substrate to form the second encapsulation member, wherein the groove extends to the first end of the first heat dissipation member, to expose a part of the first end.

28. The manufacturing method according to claim 27, wherein after the providing the groove on the surface that is of the thinned encapsulation layer and that faces away from the substrate, the method further comprises:
disposing a second solder structure on the first end of the first heat dissipation member; and
performing reflow processing on the second solder structure to form a first connecting member, wherein an end that is of the first connecting member and that faces away from the first heat dissipation member is disposed to protrude from the surface that is of the second encapsulation member and that faces away from the substrate.

29. The manufacturing method according to any one of claims 24 to 28, wherein a surface that is of the first chip and that faces the substrate has a first electrical connecting member; and
the disposing the part of the plurality of chips on the first surface comprises: disposing the first chip on the first surface, and enabling the first chip to be electrically connected to the substrate through the first electrical connecting member, wherein an end surface of an end that is of the first electrical connecting member and that is connected to the substrate forms the heat conduction region.

30. The manufacturing method according to claim 29, wherein in the thickness direction, the first heat dissipation member further comprises a second end opposite to the first end; and
the providing the substrate and the first heat dissipation member comprises: securing the second end of the first heat dissipation member to the second surface.

31. The manufacturing method according to claim 30, wherein the substrate has a second heat dissipation member; and
the securing the second end of the first heat dissipation member to the second surface comprises: enabling the vertical projection of the first heat dissipation member on the substrate to at least partially overlap a vertical projection of the second heat dissipation member on the substrate.

32. The manufacturing method according to claim 31, wherein one end of the second heat dissipation member is located inside the substrate, and the other end of the second heat dissipation member extends into the second encapsulation member in the thickness direction; and
the securing the second end of the first heat dissipation member to the second surface comprises: forming a second connecting member on the other end of the second heat dissipation member, to enable the second end of the first heat dissipation member to be secured to the other end of the second heat dissipation member through the second connecting member.

33. The manufacturing method according to claim 29, wherein in the thickness direction, the first heat dissipation member further comprises a second end opposite to the first end; and
the providing the substrate and the first heat dissipation member comprises: securing the second end of the first heat dissipation member inside the substrate.

34. The manufacturing method according to any one of claims 24 to 28, wherein a surface that is of the first chip and that faces the substrate has a second electrical connecting member; and
the disposing the other part of the plurality of chips on the second surface comprises:
disposing the first chip on the second surface, and electrically connecting the first chip to the substrate through the second electrical connecting member; and
securing the first heat dissipation member to a surface that is of the first chip and that faces away from the substrate, wherein a surface that is of the first chip and that faces the first heat dissipation member forms the heat conduction region.

35. An electronic device, comprising a housing, a circuit board, and the chip module according to any one of claims 1 to 34, wherein the chip module is disposed on the circuit board, the chip module is electrically connected to the circuit board, and both the circuit board and the chip module are assembled in the housing.
